(19) Europäisches Patentamt
European Patent Office
Office européen des brevets

(11) **EP 3 695 235 B1**

(12) **FASCICULE DE BREVET EUROPEEN**

(45) Date de publication et mention
de la délivrance du brevet:
**04.12.2024 Bulletin 2024/49**

(21) Numéro de dépôt: **18782425.5**

(22) Date de dépôt: **03.10.2018**

(51) Classification Internationale des Brevets (IPC):
**G01R 17/10** *(2006.01)*      **G01R 27/26** *(2006.01)*
**G01B 7/02** *(2006.01)*

(52) Classification Coopérative des Brevets (CPC):
**G01R 27/2605; G01B 7/023; G01R 17/10**

(86) Numéro de dépôt international:
**PCT/EP2018/076915**

(87) Numéro de publication internationale:
**WO 2019/072665 (18.04.2019 Gazette 2019/16)**

(54) **DISPOSITIF DE MESURE D'IMPÉDANCE**

IMPEDANZMESSVORRICHTUNG

IMPEDANCE MEASUREMENT DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.10.2017 FR 1759481**

(43) Date de publication de la demande:
**19.08.2020 Bulletin 2020/34**

(73) Titulaire: **FOGALE SENSORS**
**30900 Nîmes (FR)**

(72) Inventeur: **NEEL, Christian**
**30900 Nîmes (FR)**

(74) Mandataire: **IPAZ**
**Bâtiment Platon**
**Parc Les Algorithmes**
**91190 Saint-Aubin (FR)**

(56) Documents cités:
**EP-A1- 0 063 520      EP-A1- 0 378 017
EP-A1- 3 202 040      EP-A2- 1 537 377
WO-A1-2010/097459      FR-A1- 2 756 048
US-A1- 2005 007 127**

- **KAMCKE A: "DIGITALE NULLINDIKATOREN
FUER
WECHSELSPANNUNGSMESSBRUECKEN",
ELEKTRONIK, W E K A
FACHZEITSCHRIFTEN-VERLAG GMBH, DE, vol.
34, no. 1, 11 January 1985 (1985-01-11), pages 37
- 40, XP002044614, ISSN: 0013-5658**
- **BEY JR P P ET AL: "AUTONULLING MOS BRIDGE
FOR SENSOR APPLICATIONS", PROCEEDINGS
OF THE ANNUAL INTERNATIONAL
CONFERENCE OF THE ENGINEERING IN
MEDICINE AND BIOLOGY SOCIETY. ORLANDO,
OCT. 31 - NOV. 3, 1991; [PROCEEDINGS OF THE
ANNUAL INTERNATIONAL CONFERENCE OF
THE ENGINEERING IN MEDICINE AND BIOLOGY
SOCIETY], NEW YORK,, vol. 13, 31 October 1991
(1991-10-31), pages 1595 - 1596, XP000348107**

**Description**

**Domaine technique**

La présente invention concerne un dispositif de mesure d'impédance, et en particulier d'impédance capacitive dans le cadre d'une application de détection capacitive d'objets. Elle concerne également un dispositif de détection capacitive d'objets mettant en oeuvre un tel dispositif de mesure d'impédance, pour détecter l'approche et/ou le contact d'un objet. Elle concerne en outre un équipement et un robot, équipé d'un tel dispositif.

Le domaine de l'invention est, de manière non limitative, celui des dispositifs de mesure d'impédance, et en particulier ceux utilisés dans des interfaces de détection capacitive d'objets environnants, en particulier dans le domaine de la robotique.

**Etat de la technique**

La détection capacitive d'un objet, basée sur la mesure de la capacité, dite capacité électrode-objet, formée entre une électrode de détection capacitive et ledit objet, est connue de longue date. Le document FR 2 756 048 décrit une telle détection.

Généralement, cette détection capacitive met en oeuvre un dispositif de mesure d'impédance en méthode de zéro, également appelé pont de mesure d'impédance. Le pont de mesure comprend une branche, dite de mesure comportant une source $V_m$, dite de mesure, et l'impédance à mesurer, à savoir l'impédance formée par la capacité électrode-objet, et une branche de référence comportant une source $V_r$, dite de référence, et une impédance, dite de référence. La mesure d'impédance est réalisée en équilibrant le pont de mesure de sorte que la somme algébrique des courants circulant dans les deux branches, ou des tensions aux bornes des deux branches, s'annule.

Par exemple, on connait du document EP 0 063 520 A1 un dispositif de mesures successives de plusieurs capacités mises en parallèle. Des interrupteurs permettent de placer une des capacités dans un pont de mesure tandis que d'autres interrupteurs permettent de déconnecter les autres capacités de ce pont de mesure. Une fois la mesure effectuée, l'interrupteur de la capacité est ouvert pour déconnecter la capacité tandis qu'un autre interrupteur est fermé afin de réaliser la mesure d'une autre capacité. La mesure d'une capacité est réalisée grâce à une capacité ajustable d'un point de Wien.

Une solution d'équilibrage du pont consiste à modifier la tension de la source de de référence $V_r$ proportionnellement à une variable de commande k ($V_r$=k.$V_0$), de sorte à compenser l'erreur d'équilibrage. Pour la détection capacitive d'objet, cette solution donne une mesure de la capacité électrode-objet $C_m$, et nécessite *ipso facto* une inversion pour obtenir la distance entre l'électrode et l'objet. Or, du fait de cette inversion, il est nécessaire, avec un système numérique, de réaliser une mesure de la capacité électrode-objet sur un nombre de bits inutilement élevé, tel que par exemple 2n bits lorsqu'on souhaite quantifier la distance sur n bits. Cela est coûteux à implémenter.

Une autre solution consiste à modifier la tension de la source de mesure $V_m$ proportionnellement à une variable de commande k ($V_m$=k.$V_0$), de sorte à compenser l'erreur d'équilibrage. Pour la détection capacitive d'objet, cette solution donne une mesure proportionnelle à la distance entre l'électrode et l'objet, et est donc moins coûteuse à implémenter. Cependant, cette solution n'est pas parallélisable car elle nécessite de modifier la tension de la branche de mesure pour chaque électrode de mesure et introduit des capacités de fuite perturbatrices.

Un but de la présente invention est de remédier aux inconvénients précités.

Un autre but de la présente invention est de proposer un dispositif de mesure d'impédance parallélisable, moins coûteux à implémenter, en particulier dans le cadre d'une détection capacitive d'objet.

Un autre but de la présente invention est de proposer un dispositif de mesure d'impédance parallélisable, et permettant une détection plus rapide dans le cadre d'une détection capacitive d'objet.

**Exposé de l'invention**

Au moins un de ces buts est atteint avec un dispositif électronique de mesure d'impédance selon la revendication 1.

Il est à noter que si les courants sont en opposition de phase ou de polarité opposée, leur somme algébrique correspond à une différence.

Suivant des modes de réalisation, la variable de commande peut être une grandeur numérique, et/ou générée par un système numérique.

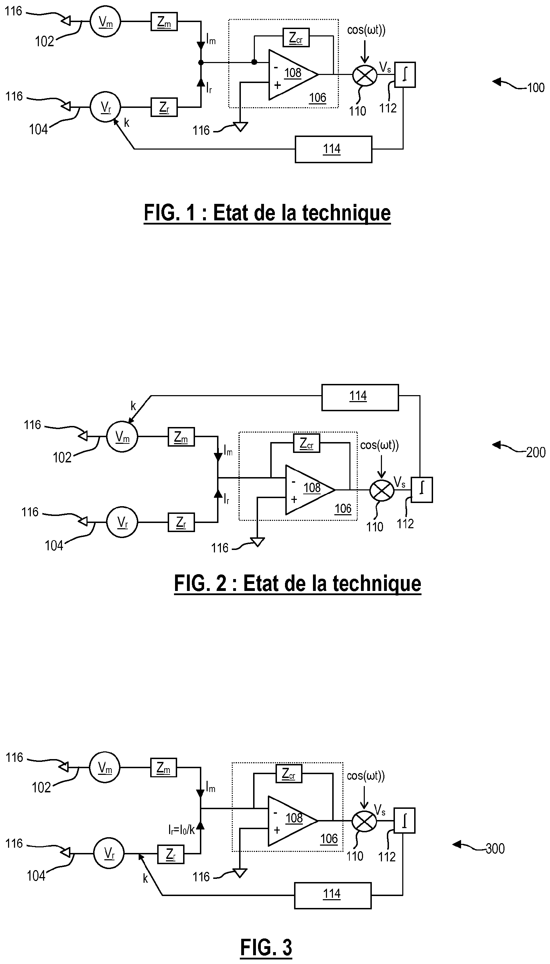

Autrement dit, contrairement aux dispositifs de l'état de la technique dans lesquels le courant est ajusté de manière proportionnelle à une variable de commande, le dispositif selon l'invention réalise une modification du courant dans la branche de référence de manière inversement proportionnelle à une variable de commande. Cette différence sera expliquée plus en détail en référence aux FIGURES 1 à 3.

Ainsi, le dispositif de mesure d'impédance selon l'invention est parallélisable car il ne nécessite pas de modifier la tension de la branche de mesure. De plus, le dispositif selon l'invention est moins coûteux à implémenter car, là où les dispositifs de l'état de la technique donnent des mesures inversement proportionnelles à l'impédance, le dispositif selon l'invention donne une mesure proportionnelle à l'impédance. Par conséquent, le dispositif selon l'invention permet d'éviter une opération d'inversion, et par conséquent, les coûts et le temps qui y sont associés.

Dans la présente demande, on raisonne pour des raisons de simplicité en régime sinusoïdal avec des signaux de pulsation $\omega$ dont les amplitudes sont algébrique ($V$, $V_0$, $V_r$,...), et on entend par impédance la valeur de la partie réelle et/ou de la partie imaginaire de l'impédance avec, ou sans, prise en compte de la fréquence/pulsation.

En particulier, dans la présente demande, par impédance $Z$ :

- d'une capacité pure de valeur « $C$ », on entend $Z=1/C$ ou $Z=1/(j\omega C)$ ;
- d'une inductance pure de valeur « $L$ », on entend $Z=L$ ou $Z=j\omega L$ ; et
- d'une résistance pure de valeur « $R$ », on entend $Z=R$ ; avec « $\omega$ » la pulsation et $j$ l'unité imaginaire.

Toutefois, il est bien entendu que l'invention peut être mise en oeuvre en utilisant toutes sortes de signaux alternatifs, par exemple carrés, triangulaires, ...), et les mêmes raisonnements sont applicables.

Dans la présente demande, « objet » désigne tout objet ou personne pouvant se trouver dans l'environnement d'un capteur, et/ou d'un dispositif tel qu'un robot équipé d'un capteur.

Dans la présente demande, deux potentiels alternatifs sont identiques à une fréquence donnée lorsqu'ils comportent chacun une composante alternative identique à cette fréquence. Ainsi, l'un au moins des deux potentiels identiques à ladite fréquence peut comporter en outre par exemple une composante continue, et/ou une composante alternative de fréquence différente de ladite fréquence donnée.

De manière similaire, deux potentiels alternatifs sont différents à la fréquence de travail lorsqu'ils ne comportent pas de composante alternative identique à cette fréquence de travail.

Dans la présente demande, pour éviter des lourdeurs rédactionnelles, le terme « potentiel de masse » ou « potentiel de masse générale » désigne un potentiel de référence de l'électronique (ou du dispositif, tel qu'un robot), qui peut être par exemple une masse électrique. Ce potentiel de masse peut correspondre à un potentiel de terre, ou à un autre potentiel relié ou non au potentiel de terre.

On rappelle par ailleurs que de manière générale, les objets qui ne sont pas en contact électrique direct avec un potentiel électrique particulier (objets électriquement flottants) tendent à se polariser par couplage capacitif au potentiel électrique d'autres objets présents dans leur environnement, tel que par exemple la terre ou des électrodes, si les surfaces de recouvrement entre ces objets et ceux de l'environnement (ou les électrodes) sont suffisamment importantes.

Dans le dispositif selon l'invention, pour au moins une branche de référence, le moyen d'ajustement peut réaliser une modification de l'amplitude d'une tension délivrée à ladite branche de référence, de manière **inversement proportionnelle** à la variable de commande.

Autrement dit, la tension délivrée à l'impédance de référence se trouvant dans ladite branche de référence peut être ajustée de manière inversement proportionnelle à la variable de commande.

Dans ce cas, suivant un exemple de réalisation non limitatif, le moyen d'ajustement peut comprendre un amplificateur dont le gain varie de manière inversement proportionnelle à la variable de commande, et disposé en aval d'une source de tension.

La source de tension peut délivrer une tension alternative d'amplitude fixe, notée par exemple $V_0$. L'amplificateur applique un gain $G$, inversement proportionnelle à la variable de commande, notée par exemple $k$. La tension, notée $V_r$, délivrée à l'impédance de référence, notée $Z_r$, est alors $V_r \sim V_0/k$. Dans ce cas, le courant, noté $I_r$, circulant dans l'impédance de référence $Z_r$, et donc dans la branche de référence, obéit à la relation : $I_r = V_r/Z_r \sim V_0/(k.Z_r)$. Le courant est donc inversement proportionnel à la variable de commande $k$.

En particulier, le moyen d'ajustement peut comprendre :

- un amplificateur, en particulier inverseur, et
- au moins un premier potentiomètre numérique, utilisé comme résistance d'entrée dudit amplificateur, et dont la résistance est ajustée proportionnellement à la variable de commande.

En particulier, ledit premier potentiomètre numérique peut être un potentiomètre numérique dont la résistance vaut $R_t(p)=k.R$, avec par exemple $R$ correspondant à la valeur de la résistance de contre-réaction de l'amplificateur, pour conserver un gain unitaire. Dans ce cas, le gain $G$ de l'amplificateur obéit à la relation $G \sim (1+1/k)$ pour un amplificateur non-inverseur, et $G \sim -1/k$ pour un amplificateur inverseur, avec $k$ la variable de commande.

Dans le cas où un amplificateur inverseur est utilisé, la source de tension délivre de préférence une tension alternative $V_0$ de même polarité que, ou en phase avec, la tension délivrée à la branche de mesure. Dans le cas où un amplificateur non-inverseur est utilisé, la source de tension délivre de préférence une tension $V_0$ de polarité opposée

à, ou en opposition de phase avec, la tension délivrée à la branche de mesure.

Suivant une caractéristique optionnelle particulièrement avantageuse, le moyen d'ajustement peut comprendre au moins un deuxième potentiomètre numérique dont la résistance est commandée proportionnellement à la variable de commande, monté en série avec le premier potentiomètre numérique, et de résolution plus élevée et/ou de résistance maximale plus faible que ledit premier potentiomètre, en particulier d'un rapport de l'ordre de 10.

Ainsi, il est possible de réaliser une mesure d'impédance plus fine et plus précise, en réalisant une approche grossière avec le premier potentiomètre numérique, puis une approche plus fine avec le deuxième potentiomètre numérique.

Pour au moins une branche de référence, le moyen d'ajustement peut réaliser une modification de l'impédance de référence de ladite branche de référence, de manière **proportionnelle** à la variable de commande.

Autrement dit, l'impédance de référence se trouvant dans ladite branche de référence peut être ajustée de manière proportionnelle à la variable de commande.

Dans ce cas, suivant un exemple de réalisation, le moyen d'ajustement peut comprendre :

- un ensemble d'au moins deux impédances disposées en série, et
- au moins un, en particulier plusieurs, interrupteur(s) commandable(s), prévu(s), chacun, pour court-circuiter ou non une desdites impédances.

Ainsi, en modifiant le nombre d'impédance court-circuité, il est possible de modifier l'impédance totale, de manière proportionnelle à la variable de commande.

Suivant un exemple d'implémentation préféré mais nullement limitatif, l'ensemble d'impédances peut comprendre n impédances de valeurs $Z_i = Z.2^i$ avec i=0...n-1, et en particulier n condensateurs de valeurs $C_i = C.2^i$ avec i=0...n-1.

Dans ce cas, l'impédance de référence obéit à la relation suivante :

$$Zr = \frac{(k.Z)}{2^n}$$

De plus, en codant la valeur de k sur n bits (avec par exemple n=8), il est alors possible de commander l'état de chaque interrupteur par un bit.

Suivant des modes de réalisation, le dispositif selon l'invention peut comprendre plusieurs branches de références.

Le dispositif selon l'invention peut notamment comprendre au moins deux branches de référence comprenant des impédances de référence de nature différente.

Par exemple, l'une de ces branches de référence peut comprendre une impédance de référence de nature purement résistive, et l'autre de ces branches de référence peut comprendre une impédance de nature purement réactive, capacitive ou inductive.

Il est ainsi possible de déterminer des composantes de nature différente de l'impédance à mesurer.

Alternativement ou en plus, le dispositif selon l'invention peut comprendre au moins deux branches de référence comprenant des impédances de référence de même nature, et alimentées par des signaux en quadrature. Autrement dit, chacune de ces branches comprend une impédance de référence qui est soit de nature résistive, soit de nature réactive.

Du fait de l'alimentation en quadrature de ces deux branches de référence, les impédances de références de même nature se comportent comme des impédances de nature différente. Par exemple, une capacité alimentée par une tension en quadrature est « vue » comme une résistance. De même que précédemment, il est ainsi possible de déterminer des composantes de nature différente de l'impédance à mesurer.

Comme expliqué précédemment, le dispositif selon l'invention peut comprendre une électronique de détection fournissant un signal d'erreur ($V_s$) dépendant de (ou fonction de, ou proportionnel à) une somme algébrique du courant circulant dans l'au moins une branche de référence et du courant circulant dans la branche de mesure.

Si les courants sont en opposition de phase ou de polarité opposée, la somme algébrique correspond à une différence.

Ce signal d'erreur ($V_s$) tend vers zéro lorsque le pont est équilibré.

Cette électronique de détection peut être réalisée partiellement ou totalement par des composants analogiques, ou par des composants numériques, ou encore par une combinaison de composants numériques et de composants analogiques.

Pour fournir un signal d'erreur en tension dépendant d'une somme de courant, l'électronique de détection peut comprendre un convertisseur courant-tension. Ce convertisseur peut comprendre un amplificateur de type transimpédance, par exemple sous la forme d'un montage correspondant à un amplificateur opérationnel avec une impédance en contre-réaction. Cette impédance de contre-réaction peut être par exemple de nature essentiellement résistive et/ou capacitive. De manière générale, il fournit en sortie une tension V = -Z I en notation complexe, avec I le courant d'entrée et Z l'impédance de contre réaction.

Dans une version préférée, en particulier adaptée à la mesure d'impédances de nature capacitive, l'électronique de détection peut comprendre un amplificateur de charge relié en un point de jonction de la branche de mesure avec l'au moins une branche de référence, entre l'impédance à mesurer et l'au moins une impédance de référence, et fournissant un signal d'erreur dépendant de (ou proportionnel à, au moins en notation complexe) la somme algébrique du courant de la branche de mesure et du courant de l'au moins une branche de référence.

Un amplificateur dit « de charge » est un amplificateur de type transimpédance avec une impédance de nature essentiellement capacitive en contre-réaction, éventuellement associée à une impédance de nature résistive en parallèle. Il fournit en sortie une tension proportionnelle à la charge ou au courant présent en entrée.

Le dispositif selon l'invention peut comprendre en outre, disposé en aval de l'électronique de détection, un démodulateur d'amplitude. Ce démodulateur d'amplitude peut comprendre par exemple :

- un détecteur d'enveloppe, qui effectue de manière numérique ou analogique un redressement du signal d'erreur suivi d'un filtrage passe-bas; ou
- un démodulateur synchrone, qui effectue une multiplication du signal d'erreur avec une porteuse de référence, suivi d'un filtrage passe-bas.

Ce démodulateur d'amplitude est destiné à recevoir le signal d'erreur et fournir, de manière numérique ou analogique, une mesure de l'amplitude de ce signal d'erreur.

Le dispositif selon l'invention peut comprendre en outre un amplificateur avec un gain proportionnel, et en particulier égal à, la variable de commande.

Cet amplificateur peut être disposé en aval de l'électronique de détection ou en aval du démodulateur d'amplitude.

Cet amplificateur permet d'obtenir un signal d'erreur proportionnel à la variable de commande, ce qui permet en très peu de mesures avec des variables de commandes différentes, ou même en une seule mesure, de déterminer la valeur de l'impédance à mesurer.

Alternativement, le dispositif selon l'invention peut comprendre un comparateur disposé en aval de l'électronique de détection et recevant le signal d'erreur ($V_s$) fourni par exemple par l'amplificateur de charge. Ce comparateur fournit un signal alternatif binaire correspondant à la polarité du signal d'erreur. Ce signal peut être comparé à un signal de référence pour déterminer (par exemple numériquement ou en utilisant une logique de type OU exclusif) le signe de l'erreur. Un tel comparateur permet ainsi de réaliser une détection de type « par approximations successives » binaire en éliminant complètement le besoin d'une démodulation du signal d'erreur.

Le dispositif selon l'invention peut en outre comprendre un module électronique, dit de commande, fournissant la variable de commande en fonction du signal issu de l'électronique de détection, éventuellement après démodulation.

Un tel module électronique peut en particulier être de nature numérique, et peut par exemple être réalisé par un microcontrôleur fournissant un signal sur n bits venant commander, par exemple, soit un/des potentiomètre(s) numériques, soit des interrupteurs de court-circuit d'un ensemble d'impédances montées en série, tels que décrits plus haut.

Suivant une implémentation nullement limitative, la branche de référence et la branche de mesure peuvent être alimentées par une même source, éventuellement par utilisation d'un transformateur ou d'un diviseur de tension résistif (constitué d'au moins deux résistances en cascades).

Suivant une implémentation particulièrement préférée, en particulier dans le cas d'une détection capacitive d'objets :

- l'impédance à mesurer peut être référencée à une masse générale, en particulier la terre, et
- le courant dans l'au moins une branche de référence peut être référencé à un potentiel électrique alternatif, dit potentiel de référence, différent de ladite masse générale à une fréquence de travail ;

ledit dispositif comprenant une source de tension alternative disposée entre ledit potentiel de référence et ladite masse générale.

Dans cette configuration, l'impédance à mesurer peut être reliée à une masse générale, ou en d'autres termes avoir une terminaison électriquement reliée à une masse générale (ou la terre). Au moins une partie de l'électronique du dispositif (dont l'au moins une branche de référence ou le courant de l'au moins une branche de référence) peut être référencée au potentiel de référence. La source de tension alternative peut imposer une différence de potentiel alternatif entre ce potentiel de référence et la masse générale.

Dans le cas d'une détection capacitive d'objets mettant en oeuvre des électrodes de mesure capacitive, l'impédance à mesurer est constituée par la capacité entre une électrode de mesure et un objet à proximité, qui est de manière générale électriquement référencé à la masse générale ou à la terre. Dans cette configuration, l'électrode de mesure est polarisée à un potentiel correspondant au potentiel de référence. Ce potentiel de référence peut alors être utilisé comme potentiel de garde pour garder électriquement lesdites électrodes de mesure et éviter les capacités de fuite parasites avec l'environnement, par exemple grâce à des électrodes de garde polarisé audit potentiel de référence.

Dans cette configuration, au moins une partie de l'électronique, dont l'électronique de détection et l'amplificateur de charges, le cas échéant, peuvent être électriquement référencée au potentiel de référence, y compris les alimentations de composants. Ainsi, les capacités de fuites sont également éliminées dans les composants.

Bien entendu il est aussi possible de mettre en oeuvre une électronique référencée (au niveau de ses alimentations) au potentiel de masse pour traiter des signaux ou des courants notamment issus des branches de référence et de mesure référencés au potentiel de référence.

Le dispositif selon l'invention peut être réalisé partiellement ou totalement par des composants analogiques ou par des composants numériques, ou par une combinaison de composants numériques et de composants analogiques.

Le dispositif selon l'invention est un dispositif de mesure d'impédance capacitive comprenant une impédance à mesurer de nature essentiellement capacitive.

De même le dispositif selon l'invention comprend une impédance de référence de nature capacitive ou essentiellement capacitive.

Une telle version du dispositif selon l'invention est particulièrement pertinente dans le cadre d'une détection capacitive d'objets, en mesurant l'impédance formée par une capacité de couplage entre l'objet à détecter et une ou des électrodes de mesure capacitives.

Suivant un autre aspect de la même invention, il est proposé un procédé de mesure d'impédance, selon la revendication 13.

En particulier, le procédé selon l'invention peut comprendre en termes d'étape(s), ou de caractéristique(s), de manière isolée ou combinée, chacune des caractéristiques du dispositif de mesure d'impédance selon l'invention, qui ne seront pas reprises ici par souci de concision.

Suivant un premier mode de réalisation, la valeur de la variable de commande correspondant à l'équilibre entre la branche de mesure et l'au moins une branche de référence peut être mesurée par une pluralité d'itérations.

Suivant un autre mode de réalisation, la valeur de la variable de commande correspondant à un équilibre entre la branche de mesure et l'au moins une branche de référence peut être calculée à partir de la valeur fournie par au moins une mesure réalisée avec le dispositif selon l'invention.

Suivant encore un autre aspect de la présente invention, il est proposé un dispositif de détection capacitive d'un objet comprenant :

- au moins une électrode, dite de mesure, et
- au moins un dispositif de mesure d'impédance selon l'invention agencé pour mesurer l'impédance capacitive formée entre ladite électrode de mesure et ledit objet.

Dans ce cas, la ou chaque impédance de référence est une impédance de nature purement capacitive.

Bien entendu, le dispositif de détection capacitive peut comprendre plusieurs électrodes de mesure.

Suivant un mode de réalisation, un dispositif de mesure d'impédance peut être commun à une pluralité, ou toutes, les électrodes de mesure. Dans ce cas, le dispositif de détection capacitive peut comprendre un moyen de scrutation reliant ledit dispositif de mesure à chacune desdites électrodes de mesure, alternativement ou séquentiellement.

Alternativement ou en plus, le dispositif de détection capacitive peut comprendre plusieurs dispositifs de mesure, chaque dispositif de mesure étant commune à un ensemble de plusieurs électrodes de mesure et relié alternativement ou séquentiellement à chacune des électrodes de mesure dudit ensemble.

Un tel dispositif de détection capacitive peut être intégré, partiellement ou totalement, dans une interface de détection capacitive, ou dans un équipement pour un appareil ou un robot tel qu'une pièce d'habillage de type coque ou peau ou encore revêtement.

Suivant encore un autre aspect de la présente invention, il est proposé un équipement pour robot muni :

- d'au moins un dispositif de détection capacitive selon l'invention ; et/ou
- d'au moins un dispositif de mesure d'impédance selon l'invention.

Un tel équipement peut être amovible ou démontable.

Un tel équipement peut être souple ou rigide.

Un tel équipement peut être une pièce d'habillage du robot, telle qu'une coque ou une peau ou encore un revêtement.

Un tel équipement peut être une pièce fonctionnelle, tel qu'une tête fonctionnelle se présentant sous la forme d'un outil ou d'un porte-outil.

Suivant encore un autre aspect de la présente invention, il est proposé un robot muni :

- d'un équipement selon l'invention ; et/ou
- d'au moins un dispositif de détection capacitive selon l'invention ; et/ou
- d'au moins un dispositif de mesure d'impédance selon l'invention.

Un tel robot peut être un bras robotisé articulé ou non.

Un tel robot peut être un humanoïde.

Un tel robot peut être généralement tout appareil ou véhicule motorisé.

## Description des figures et modes de réalisation

D'autres avantages et caractéristiques apparaîtront à l'examen de la description détaillée d'exemples nullement limitatifs, et des dessins annexés sur lesquels :

- les FIGURES 1 et 2 sont des représentations schématiques de dispositif de mesure d'impédance de l'état de la technique ;
- la FIGURE 3 est une représentation schématique du principe d'un dispositif de mesure d'impédance selon l'invention ;
- les FIGURES 4-14 sont des représentations schématiques de différents exemples de réalisation d'un dispositif de mesure d'impédance selon l'invention ; et
- la FIGURE 15 est une représentation schématique d'un exemple de réalisation d'un dispositif de détection capacitive selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

Les modes de réalisation sont décrits en utilisant des signaux harmoniques, mais il est bien entendu que l'invention peut être mise en oeuvre avec tous types de signaux alternatifs (carré, triangulaire, ...).

La FIGURE 1 est une représentation schématique du principe d'un premier type de dispositif de mesure d'impédance selon l'état de la technique.

Le dispositif de mesure d'impédance 100, également appelé pont de mesure d'impédance, comprend une première branche 102, dite branche de mesure. La branche de mesure 102 comprend une impédance, notée $Z_m$, dont la valeur doit être mesurée. La branche de mesure 102 est excitée par une source électrique alternative $V_m(t) = V_m \cos(\omega t)$, d'amplitude fixe $V_m$, et de pulsation $\omega$.

Le dispositif de mesure d'impédance 100 comprend également une branche 104, dite branche de référence. La branche de référence 104 comprend une impédance, notée $Z_r$. Cette impédance $Z_r$ est de préférence de même nature (résistive, capacitive ou inductive) qu'au moins une composante de l'impédance à mesurer $Z_m$. La branche de référence 104 est excitée par une source électrique alternative variable $V_r(t) = V_r \cos(\omega t + \pi)$, d'amplitude $V_r$ et en opposition de phase par rapport à la source électrique alternative $V_m(t)$. L'amplitude la tension délivrée par la source de référence $V_r$ est ajustée de manière **proportionnelle** à une variable de commande k, telle que $V_r = k.V_0$, avec $V_0$ une source électrique alternative d'amplitude fixe.

Le dispositif de mesure 100 comprend une électronique de détection 106 comprenant un amplificateur de type transimpédance 108 (ou plus simplement « amplificateur transimpédance ») dont la borne « - » est reliée à un point de jonction des branches de mesure 102 et de référence 104, entre les impédances de mesure $Z_m$ et de référence $Z_r$. Une impédance de contre réaction $Z_{cr}$ reliée la sortie de l'amplificateur transimpédance 108 à son entrée « - ».

L'électronique de détection 106 peut optionnellement être associée à un bloc 110 de démodulation synchrone utilisant comme un signal de référence un signal électrique alternatif de forme similaire aux signaux à démoduler, soit dans les exemples présentés de type $\cos(\omega t)$, et à un bloc d'intégration 112.

L'amplificateur transimpédance 108 fournit un signal de sortie, ou signal d'erreur, noté $V_s(t)$ en fonction du temps t, proportionnel à la somme algébrique du courant $I_m(t)$ de la branche de référence 102 et du courant $I_r(t)$ de la branche de mesure 104. Ce signal d'erreur est démodulé par le bloc 110 pour en extraire l'amplitude $V_s$, et intégré par l'intégrateur 112. L'intégrateur 112 permet de réaliser une boucle de contre-réaction de type Proportionnel-Intégral (PI), qui évite les effets de trainée.

Pour obtenir un signal d'erreur $V_s(t)$ en phase avec les signaux des source électrique $V_m(t)$ et $V_r(t)$, plus facile à traiter, il est préférable d'utiliser une impédance de contre réaction $Z_{cr}$ de même nature que l'impédance de mesure $Z_m$. En particulier, si l'impédance de mesure $Z_m$ est de nature capacitive ou essentiellement capacitive, il est préférable de mettre en oeuvre un amplificateur transimpédance 108 avec une impédance de contre réaction $Z_{cr}$ de nature capacitive ou essentiellement capacitive, auquel cas l'amplificateur transimpédance 108 est appelé « amplificateur de charge » 108.

Le signal issu de l'intégrateur 112 est fourni à un module de commande 114, qui peut par exemple être un microcontrôleur. Le module de commande 114 fournit une variable de commande, noté k, qui vient moduler l'amplitude $V_r$ de la tension fournie par la source de référence variable $V_r(t)$. L'objectif est d'annuler la somme algébrique du courant de référence $I_r(t)$ et du courant $I_m(t)$, et donc d'annuler le signal d'erreur $V_s(t)$ fourni par l'amplificateur transimpédance 108, à tout instant t.

La branche de mesure 102, la branche de référence 104 ainsi que la borne « + » de l'amplificateur transimpédance 108 sont reliées, dans l'exemple représenté sur la FIGURE 1, à un potentiel de référence 116.

A l'équilibre, les courants dans les branches de référence 104 et de mesure 102 vérifient la relation suivante, à tout instant :

$$I_r(t) + I_m(t) = 0$$

C'est-à-dire :

$$V_r(t)/Z_r = -V_m(t)/Z_m$$

$$Z_m = -(V_m(t)/V_r(t)).Z_r$$

En prenant en compte le fait que les sources de tension $V_r(t)$ et $V_m(t)$ sont en opposition de phase, et donc de polarité opposée, cette relation peut s'écrire, en amplitudes :

$$Z_m = (V_m/V_r).Z_r$$

Ainsi, pour une valeur $k_e$ de la variable de commande k correspondant à l'équilibre, on a :

$$Z_m = (V_m/k_e.V_0).Z_r.$$

On comprend aisément que l'impédance $Z_m$ est inversement proportionnelle à la variable de commande k. Par conséquent, à partir de la valeur $k_e$, il est nécessaire de réaliser une opération mathématique d'inversion pour déterminer $Z_m$.

Or, pour obtenir une valeur de $Z_m$ avec une précision sous n bits après inversion de k, il est nécessaire de déterminer k avec une précision de 2n bits. Ce qui est coûteux.

Il existe un deuxième type de dispositif de mesure d'impédance connu, dont un exemple est représenté sur la FIGURE 2, et qui permet de pallier cette problématique de coût lié au dispositif 100.

La FIGURE 2 est une représentation schématique du principe d'un deuxième type de dispositif de mesure d'impédance selon l'état de la technique.

Le dispositif de mesure d'impédance 200 comprend tous les éléments du dispositif 100 de la FIGURE 1.

A la différence du dispositif 100 de la FIGURE 1, dans le dispositif 200 de la FIGURE 2, la source $V_r$ excitant la branche de référence 104 est d'amplitude fixe et c'est la source $V_m$ excitant la branche de mesure 102 qui a une amplitude variable proportionnellement à la variable de commande k, et le module de commande 114 vient contrôler cette source $V_m$ et non la source $V_r$.

Autrement dit, dans le dispositif 200 de la FIGURE 2, on a $V_m = k.V_0$, avec $V_0$ une source électrique alternative d'amplitude fixe et k la variable de commande délivrée par le module commande 114.

En condition d'équilibre on a toujours :

$$I_r(t) + I_m(t) = 0$$

C'est-à-dire :

$$V_r(t)/Z_r = -V_m(t)/Z_m$$

En prenant en compte le fait, comme précédemment, que les sources de tension $V_r(t)$ et $V_m(t)$ sont en opposition de phase, et donc de polarité opposée, cette relation peut s'écrire, en amplitudes :

$$Z_m = (V_m/V_r).Z_r$$

Ainsi, pour une valeur $k_e$ permettant d'obtenir l'équilibre, on a :

$$Z_m = ((k_e.V_0)/V_r).Z_r.$$

On comprend que l'impédance $Z_m$ est proportionnelle à la variable de commande k.

Par conséquent, à partir de la valeur $k_e$, il n'est pas nécessaire de réaliser une opération mathématique d'inversion pour déterminer $Z_m$, contrairement au dispositif 100 de la FIGURE 1.

Le dispositif 200 de la FIGURE 2 est donc moins coûteux que le dispositif 100 de la FIGURE 1.

Cependant, le dispositif 200 de la FIGURE 2 n'est pas parallélisable pour une pluralité d'impédances à déterminer car la source $V_m$ se trouvant sur la branche de mesure 102 ne peut pas être commune à toutes les impédances à déterminer.

De plus, dans une application de détection capacitive les impédances à déterminer sont des impédances purement capacitives entre des électrodes de mesure et un objet à détecter. Or, il n'est pas possible d'exciter les électrodes de mesure à des potentiels différents, car deux électrodes de mesures voisines excitées à des potentiels différents génèrent entre elles un couplage capacitif parasite et donc des capacités de fuite qui gênent la détection capacitive.

L'invention permet de pallier les inconvénients de chacun des dispositifs des FIGURES 1 et 2. En particulier, le dispositif de mesure d'impédance selon l'invention est :

- moins coûteux que le dispositif 100 de la FIGURE 1, et
- est parallélisable, contrairement au dispositif de la FIGURE 2.

La FIGURE 3 est une représentation schématique du principe du dispositif de mesure d'impédance selon l'invention.

Le dispositif de mesure d'impédance 300 de la FIGURE 3, comprend tous les éléments du dispositif 100 de la FIGURE 1.

A la différence du dispositif 100 de la FIGURE 1, dans le dispositif 300 de la FIGURE 3, la valeur du courant $I_r$ dans la branche de référence est ajustée, de manière **inversement proportionnelle** à la variable de commande k fourni le module de commande 114, de sorte que, en amplitude, $I_r = I_0/k$ avec $I_0$ une valeur d'amplitude de courant de référence.

Dans ces conditions, la tension en sortie de l'amplificateur transimpédance 108, ou signal d'erreur $V_s$ vaut :

$$V_s(t) = -Z_{cr}[\, i_m(t) + i_r(t)\,] = -Z_{cr}[V_m/Z_m + I_o/k]$$

On peut utiliser cette équation pour déterminer directement l'impédance à mesurer $Z_m$ en fonction du signal d'erreur $V_s$ et de la variable de commande appliquée k, en une ou plusieurs mesures.

On peut également rechercher une condition d'équilibre, correspondant à un signal d'erreur nul $V_s(t) = 0$ à tout instant t. Pour cela il faut annuler la somme des courants :

$$I_r(t) + I_m(t) = 0$$

Pour pouvoir annuler la somme des courants, il est nécessaire qu'ils soient en opposition de phase, ou de polarité opposée. Dans ce cas, on peut écrire, en amplitudes :

$$I_0/k = V_m/Z_m$$

$$Z_m = (k.V_m)/I_0$$

Ainsi, pour une valeur $k_e$ permettant d'obtenir l'équilibre, on a :

$$Z_m = (k_e.V_m)/I_0.$$

On comprend donc que l'impédance $Z_m$ est proportionnelle à la variable de commande k.

De plus, la tension de la source $V_m$ excitant la branche de mesure 102 étant d'amplitude fixe, ou plus précisément d'amplitude fixe par rapport à la variable de commande k ou indépendante de cette variable de commande k, le dispositif 300 de la FIGURE 3 peut être parallélisable pour mesurer une pluralité d'impédances à tour de rôle sans avoir à modifier la source de référence $V_m$, et sans introduire d'impédances parasites.

Par ailleurs, comme expliqué précédemment, l'amplificateur transimpédance est réalisé sous la forme d'un montage correspondant à un amplificateur opérationnel avec une impédance en contre-réaction. Il s'ensuit, du fait du principe même de fonctionnement d'un amplificateur opérationnel, que les entrée « + » et « - » de cet amplificateur transimpédance sont au même potentiel. L'entrée « + » étant au potentiel de référence 116, l'impédance à mesurer $Z_m$ est également reliée électriquement au potentiel de référence 116. La tension de la source $V_m$ se retrouve donc aux bornes de l'impédance à mesurer $Z_m$.

Ainsi, selon l'invention, la tension $V_m$ aux bornes de l'impédance à mesurer $Z_m$ et le courant $I_m = V_m/Z_m$ traversant cette impédance et plus généralement la branche de mesure sont indépendants de la variable de commande k et peuvent être maintenus constants ou d'amplitude fixe lors des mesures. En outre, la tension aux bornes de l'impédance à mesurer $Z_m$ peut être parfaitement maîtrisée et connue puisqu'il peut s'agir directement de la tension de la source $V_m$.

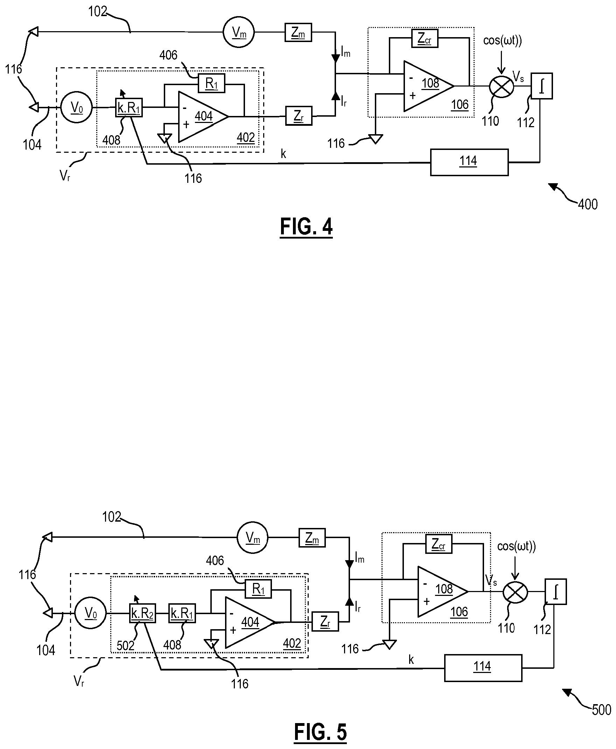

La FIGURE 4 est une représentation schématique d'un premier exemple de réalisation d'un dispositif de mesure d'impédance selon l'invention.

Le dispositif de mesure d'impédance 400 de la FIGURE 4, comprend tous les éléments du dispositif 300 de la FIGURE 3.

Dans l'exemple représenté sur la FIGURE 4, la valeur du courant $I_r$ dans la branche de référence 104 est ajustée de manière inversement proportionnelle à la variable de commande k, en ajustant l'amplitude de la tension fournie à la branche de référence 104, de manière inversement proportionnelle à la variable de commande k.

Pour ce faire, le dispositif 400 met en oeuvre, sur la branche de référence 104, une source de tension variable $V_r$ délivrant une tension dont l'amplitude est **inversement proportionnelle** à la variable de commande k.

La source de tension $V_r$ comprendre une source de tension alternative d'amplitude fixe $V_0$ associé à un étage d'amplification 402 dont le gain est inversement proportionnel à la variable de commande k.

En particulier, l'étage d'amplification 402 comprend un amplificateur opérationnel 404 dont :

- l'entrée « + » est reliée au potentiel de référence 116 ; et
- l'entrée « - » est reliée à sa sortie par une résistance de contre-réaction 406, de valeur $R_1$.

De plus, l'entrée « - » est reliée à une résistance d'entrée 408 dont la valeur est ajustée de manière proportionnelle à la variable de commande k. En particulier, la valeur de la résistance d'entrée est égale à $k.R_1$. La résistance d'entrée 408 peut être un potentiomètre numérique dont la valeur est ajustée de manière proportionnelle à la valeur de commande k.

Dans ces conditions, l'étage d'amplification 402 réalise une amplification de gain G négatif et dont la valeur obéit à la relation suivante :

$$G = -R_1/(k.R_1) = -1/k$$

Par conséquent, la tension fournie par la source de tension variable $V_r$ à la branche de référence 104 obéit à la relation suivante :

$$V_r(t) = -V_0(t)/k$$

On en déduit que le courant $I_r$ dans la branche de référence obéit à la relation suivante :

$$I_r(t) = \frac{V_r(t)}{Z_r} = -\frac{V_0(t)}{k.Z_r}$$

Par conséquent, le courant $I_r$ est ajusté de manière inversement proportionnelle à la variable de commande k.

A l'équilibre, on a $I_r(t) + I_m(t) = 0$. On en déduit directement :

$$-\frac{V_0(t)}{k_e.Z_r} = -I_m(t) = -\frac{V_m(t)}{Z_m}$$

Soit, en amplitudes :

$$Z_m = \frac{k_e.Z_r V_m}{V_0}$$

Ainsi, l'impédance à mesurer $Z_m$ est déterminée de manière directement proportionnelle à la variable de commande k. Il n'est donc pas nécessaire de réaliser une opération d'inversion.

On peut noter que dans cette configuration, du fait de la présence de l'étage d'amplification 402 inverseur utilisé pour générer la source $V_r$ de la branche de référence, les sources de tension alternative $V_0$ de la branche de référence et $V_m$ de la branche de mesure doivent être en phase ou de même polarité pour pouvoir annuler la somme des courants.

Dans le cas particulier où toutes les impédances sont des impédances purement capacitives, c'est-à-dire $Z_m=1/C_m$ et $Z_r=1/C_r$, on a :

$$\frac{1}{C_m} = \frac{k_e.V_m}{V_0}\frac{1}{C_r}$$

Dans le cadre d'une application de détection capacitive, la capacité $C_m$ représente la capacité formée par une électrode de mesure capacitive et un objet. Dans ce cas, la distance D séparant ladite électrode de mesure dudit objet est proportionnelle à la valeur de l'impédance formée par cette capacité $C_m$ selon la relation suivante :

$$D = \varepsilon_0\varepsilon_r S\frac{1}{C_m}$$

avec $\varepsilon_0, \varepsilon_r$ les permittivités du vide et du matériau d'interface respectivement, et S la surface de recouvrement de l'électrode de mesure et de l'objet.

On en déduit que la distance D obéit à la relation suivante :

$$D = \varepsilon_0\varepsilon_r S\frac{k_e.V_m}{V_0}\frac{1}{C_r}$$

On voit clairement que la distance D est directement proportionnelle à la variable de commande k. Ainsi, la distance D est proportionnelle à la valeur k permettant d'obtenir l'équilibre.

La FIGURE 5 est une représentation schématique d'un deuxième exemple de réalisation d'un dispositif de mesure d'impédance selon l'invention.

Le dispositif de mesure d'impédance 500 de la FIGURE 5, comprend tous les éléments du dispositif 400 de la FIGURE 4.

A la différence du dispositif 400, dans le dispositif 500, l'étage de gain 402 comprend en plus du potentiomètre numérique 408, un deuxième potentiomètre numérique 502, en série avec le premier potentiomètre numérique 408, dont la valeur est ajustable de manière proportionnelle à la variable de commande k.

En particulier, le deuxième potentiomètre numérique 502 peut avoir une valeur donnée par la relation $k.R_2$.

Les résistances $R_1$ et $R_2$ peuvent être choisies de sorte que le pas d'ajustement du deuxième potentiomètre numérique soit plus petit comparé au pas d'ajustement du premier potentiomètre numérique 408. Ainsi, il est possible de réaliser une mesure plus précise de l'impédance $Z_m$.

En particulier, il est possible de réaliser une première phase d'itérations avec un gros pas d'ajustement avec le premier potentiomètre numérique 408, puis une deuxième phase d'itérations avec un petit pas d'ajustement avec le deuxième potentiomètre numérique 502.

Par exemple $R_2=R_1/10$, ce qui permet d'avoir un pas d'ajustement dix fois plus petit, et donc une précision 10 fois plus grande, avec le deuxième potentiomètre numérique 502.

Bien entendu, l'invention n'est pas limitée à un ou deux potentiomètres numériques, et il est possible d'utiliser un nombre de potentiomètres numériques supérieur ou égal à 1.

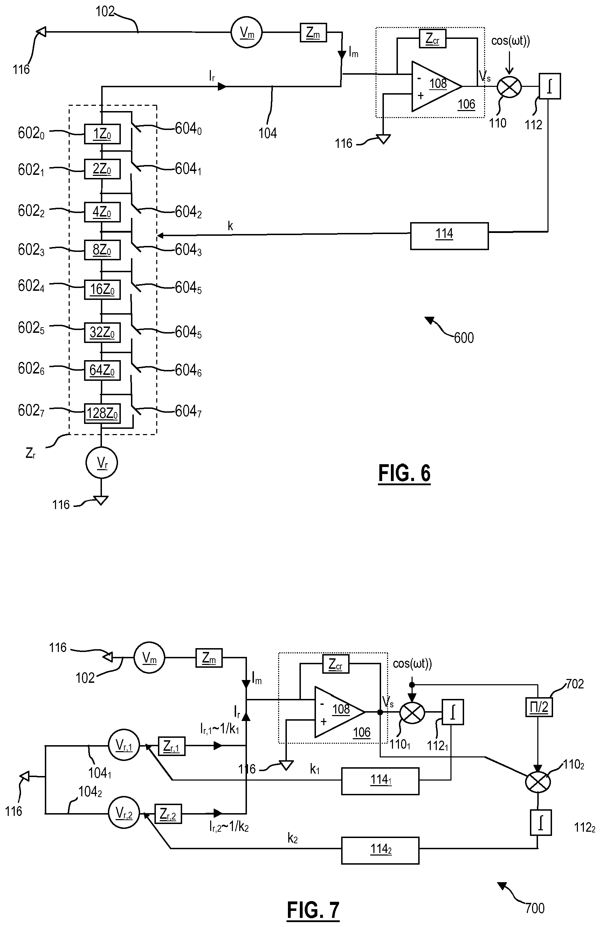

La FIGURE 6 est une représentation schématique d'un autre exemple de réalisation d'un dispositif de mesure d'impédance selon l'invention.

Le dispositif de mesure d'impédance 600 de la FIGURE 6, comprend tous les éléments du dispositif 300 de la FIGURE 3.

Dans l'exemple représenté sur la FIGURE 6, la valeur du courant $I_r$ dans la branche de référence 104 est ajustée de manière inversement proportionnelle à la variable de commande k, en ajustant la valeur de l'impédance de référence $Z_r$ de la branche de référence 104 de manière proportionnelle à la variable de commande k.

Pour ce faire, l'impédance de référence $Z_r$ est formée par un ensemble de huit impédances $602_0$-$602_7$, montées en série, et de valeurs respectives $2^n.Z_0$, avec n=0...7. Ainsi, l'impédance de référence $Z_r$ est formée par huit impédances $602_0$-$602_7$ de valeurs respectives $Z_0$, $2Z_0$, $4Z_0$, $8Z_0$, $16Z_0$, $32Z_0$, $64Z_0$ et $128Z_0$. Chaque impédance 602 peut être court-circuitée par un interrupteur, respectivement $604_0$-$604_7$.

La variable de commande k est une valeur fournie sur huit bits et chaque interrupteur $604_0$-$604_7$ est commandé par un bit de la variable de commande de sorte que lorsque le bit est égale 0 l'interrupteur est ouvert et lorsque le bit est égale 1 l'interrupteur est fermé. La valeur de k est donc écrit en binaire sur la configuration des interrupteurs $604_0$-$604_7$. Dans ces conditions, l'impédance $Z_r$ a pour valeur :

$$Z_r = Z_0.k/2^n$$

Par conséquent, $Z_r$ varie de manière proportionnelle à la variable de commande k.

A l'équilibre, on a $I_r(t) + I_m(t) = 0$. On en déduit directement que la

$$\frac{V_r(t)}{k_e.(Z_0/2^n)} = -I_m(t) = -\frac{V_m(t)}{Z_m}$$

En prenant en compte le fait comme précédemment que les sources de tension $V_r(t)$ et $V_m(t)$ sont en opposition de phase, et donc de polarité opposée, cette relation peut s'écrire, en amplitudes :

$$Z_m = k_e.Z_0.V_m \frac{1}{V_r.2^n}$$

Ainsi, l'impédance à mesurer $Z_m$ est déterminée de manière directement proportionnelle à la variable de commande k. Il n'est donc pas nécessaire de réaliser une opération d'inversion.

Dans le cas particulier où toutes les impédances sont des impédances purement capacitives, c'est-à-dire $Z_m=1/C_m$ et $Z_0=1/C_0$, on a :

$$\frac{1}{C_m} = \frac{1}{C_0} \frac{k_e.V_m}{V_r.2^n}$$

Dans le cadre d'une application de détection capacitive, et en utilisant la relation reliant la distance à la capacité $C_m$, en déduit que la distance D obéit à la relation suivante :

$$D = \varepsilon_0 \varepsilon_r S \frac{1}{C_0} \frac{k_e . V_m}{V_r . 2^n}$$

On voit clairement que la distance D est directement proportionnelle à la variable de commande k. Ainsi, la distance D est proportionnelle à la valeur $k_e$ permettant d'obtenir l'équilibre.

La FIGURE 7 est une représentation schématique d'un autre exemple de réalisation d'un dispositif de mesure d'impédance selon l'invention.

Le dispositif de mesure d'impédance 700 de la FIGURE 7, comprend tous les éléments du dispositif 300 de la FIGURE 3.

A la différence du dispositif 300, le dispositif 700 comprend deux branches de références $104_1$ et $104_2$.

Chaque branche de référence $104_1$, $104_2$ est équilibrée selon l'une quelconque des principes décrits en référence aux FIGURES 4-6. Chaque branche de référence $104_1$, $104_2$ comprend une excitation alternative, respectivement $V_{r,1}$ et $V_{r,2}$, et une impédance de référence respectivement $Z_{r,1}$ et $Z_{r,2}$.

Le dispositif 700 permet par exemple de mesurer différentes composantes (active et réactive) de l'impédance à mesurer $Z_m$. Les impédances de référence $Z_{r,1}$, $Z_{r,2}$ correspondent chacune, respectivement, à une composante de l'impédance à mesurer $Z_m$. Elles introduisent un déphasage en conséquence entre la tension et le courant dans leur branche de référence, qui permet de compenser une composante du courant de la branche de mesure avec un déphasage similaire. Par exemple, si l'impédance à mesurer comprend des composantes résistives et capacitives, on utilise des impédances de référence $Z_{r,1}$, $Z_{r,2}$ de nature respectivement résistive et capacitive. De la même manière on peut mesurer une composante de nature inductive avec une impédance de référence de nature inductive.

A chaque branche de référence $104_1$, $104_2$ est associé un module de commande, respectivement $114_1$ et $114_2$, fournissant à chaque branche une variable de commande, respectivement $k_1$ et $k_2$, utilisé pour ajuster la valeur du courant dans chaque branche, respectivement $I_{r,1}$ et $I_{r,2}$ de manière inversement proportionnelle telle que $I_{r,1} \sim 1/k_1$ et $I_{r,2} \sim 1/k_2$.

A chaque branche $104_1$, $104_2$ est associé un bloc de démodulation synchrone, respectivement $110_1$ et $110_2$, et un bloc d'intégration respectivement $112_1$ et $112_2$.

Dans cette configuration, l'équilibre du pont est atteint lorsque la somme algébrique du courant $I_m$ de la branche de mesure 102 et des courants de toutes les branches de référence $104_1$ et $104_2$ est nulle à tout instant :

$$I_m(t) + I_{r,1}(t) + I_{r,2}(t) = 0.$$

Lorsque les impédances $Z_{r,1}$ et $Z_{r,2}$ sont de nature différente, et correspondant aux différentes composantes de l'impédance à mesurer $Z_m$, les excitations $V_{r,1}$ et $V_{r,2}$ sont en en phase.

Il est également possible, pour détecter des composantes différentes (résistive et réactive) de l'impédance à mesurer $Z_m$, d'utiliser des impédances $Z_{r,1}$ et $Z_{r,2}$ de même nature, à savoir résistive ou capacitive ou encore inductive, et des sources d'excitations $V_{r,1}$ et $V_{r,2}$ déphasées (par exemple en quadrature), pour reproduire le déphasage des courants des branches de référence qui seraient générés par des impédances de référence de nature différente.

Dans tous les cas, un bloc de déphasage 702 est utilisé pour appliquer un décalage de phase de $\Pi/2$ à la porteuse pour la démodulation synchrone pour l'une des deux branches $104_1$ et $104_2$, et détecter ainsi ses composantes en phase en en quadrature. Dans l'exemple de la FIGURE 7, le bloc de démodulation 702 est utilisé pour la branche $104_2$.

Bien entendu, l'invention n'est pas limitée à une ou deux branches de référence, et il est possible d'utiliser un nombre de branches de référence supérieur ou égal à 1.

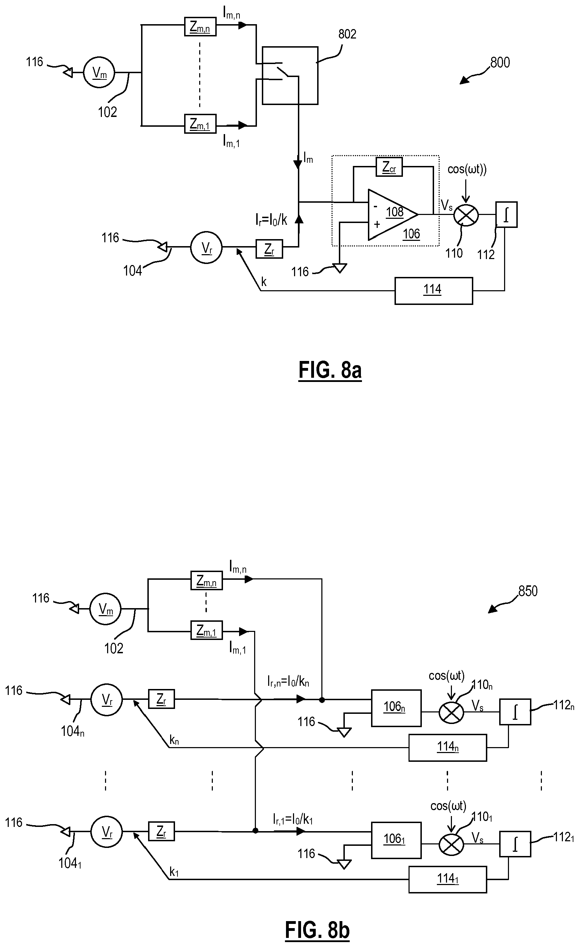

La FIGURE 8a et la FIGURE 8b sont des représentations schématiques d'exemples de réalisation de dispositifs de mesure d'impédance selon l'invention permettant de mesurer une pluralité d'impédances $Z_{m,1}$-$Z_{m,n}$.

Le dispositif de mesure d'impédance 800 de la FIGURE 8a comprend tous les éléments du dispositif 300 de la FIGURE 3.

A la différence du dispositif 300, le dispositif 800 permet de mesurer, à tour de rôle ou séquentiellement, une pluralité d'impédances $Z_{m,1}$-$Z_{m,n}$.

Pour ce faire, le dispositif 800 comprend un moyen de scrutation 802 permettant de relier sélectivement les impédances à mesurer $Z_{m,1}$-$Z_{m,n}$ à l'électronique de détection 106 et à la branche de référence 104. Dans l'exemple illustré, la source $V_m$ de la branche de mesure 102 est commune à toutes les impédances à mesurer. Le moyen de scrutation 802 peut comprendre des interrupteurs commandables, par exemple par le module de commande 114, et permettant de relier l'électronique de détection 106 à chacune des impédances à mesurer $Z_{m,i}$ à tour de rôle.

De préférence, le moyen de scrutation 802 permet de relier les impédances à mesurer $Z_{m,1}$-$Z_{m,n}$, soit à l'électronique de détection 106, soit au potentiel de référence 116. Cela est particulièrement important si les impédances à mesurer $Z_{m,i}$ sont capacitives, pour éviter les couplages parasites.

Pour chaque impédance $Z_{m,i}$, comme précédemment, la condition d'équilibre est donné par la relation $I_{m,i}(t) + I_r(t) = 0$, avec $I_{m,i}$ le courant parcourant cette impédance $Z_{m,i}$.

Comme expliqué précédemment, la tension aux bornes des impédances à mesurer $Z_{m,i}$ est identique et correspond à la tension, dans le schéma illustré, à la tension de la source $V_m$. Cette propriété est très importante pour pouvoir mesurer une pluralité d'impédances $Z_{m,i}$ sans couplages électriques parasites entre elles, notamment lorsqu'il s'agit d'impédances capacitives.

Le dispositif 800 peut être combiné à chacun des dispositifs des FIGURES 4-7.

Le dispositif de mesure d'impédance 850 de la FIGURE 8b comprend tous les éléments du dispositif 300 de la FIGURE 3.

A la différence du dispositif 300, le dispositif 850 permet de mesurer en parallèle ou simultanément une pluralité d'impédances $Z_{m,1}$-$Z_{m,n}$, avec une pluralité de voies de mesures parallèles indépendantes.

Pour ce faire, il comprend une pluralité de dispositifs de mesure d'impédances 300 constituant chacun une voie de mesure, par exemple selon les mises en oeuvre des FIGURES 4-7, fonctionnant en parallèle.

Chaque impédance $Z_{m,1}$-$Z_{m,n}$ est reliée à une électronique de détection $106_1$-$106_n$ distincte et constitue avec une branche de référence $104_1$-$104_n$ distincte un pont distinct.

La valeur du courant $I_{r,i}$ dans chaque branche de référence $104_i$ est ajustée de manière inversement proportionnelle à une variable de commande $k_i$ distincte fournie par un module de commande distinct 114i (ou un module de commande commun 114), de sorte à déterminer une condition d'équilibre :

$$I_{r,i}(t) + I_m(t) = 0$$

Suivant un mode de réalisation particulièrement avantageux, le dispositif 850 comprend une source $V_m$ commune à toutes les impédances à mesurer. Ainsi, toutes les impédances à mesurer $Z_{m,1}$-$Z_{m,n}$ sont polarisées au même potentiel, ce qui est essentiel lorsque par exemple ces impédances à mesurer sont des capacités entre des électrodes de mesure capacitives et un objet.

Par ailleurs, le dispositif 850 permet des mesures indépendantes, en parallèle, ou simultanées, ou de manière asynchrone, de toutes les impédances $Z_{m,1}$-$Z_{m,n}$.

Bien entendu, les différentes voies de mesure du dispositif 850 peuvent être réalisées de toutes manières, en particulier avec des composants distincts et/ou des composants communs pour chaque voie de mesure.

Le dispositif 850 peut être combiné à chacun des dispositifs des FIGURES 4-8a.

En particulier, certaines ou toutes les voies de mesures du dispositif 850 peuvent comprendre un moyen de scrutation 802 comme illustré à la FIGURE 8a pour mesurer séquentiellement une pluralité d'impédances. Par ailleurs, le dispositif peut comprendre une source $V_m$ commune à toutes les impédances à mesurer, séquentiellement et/ou avec des voies de mesure parallèles.

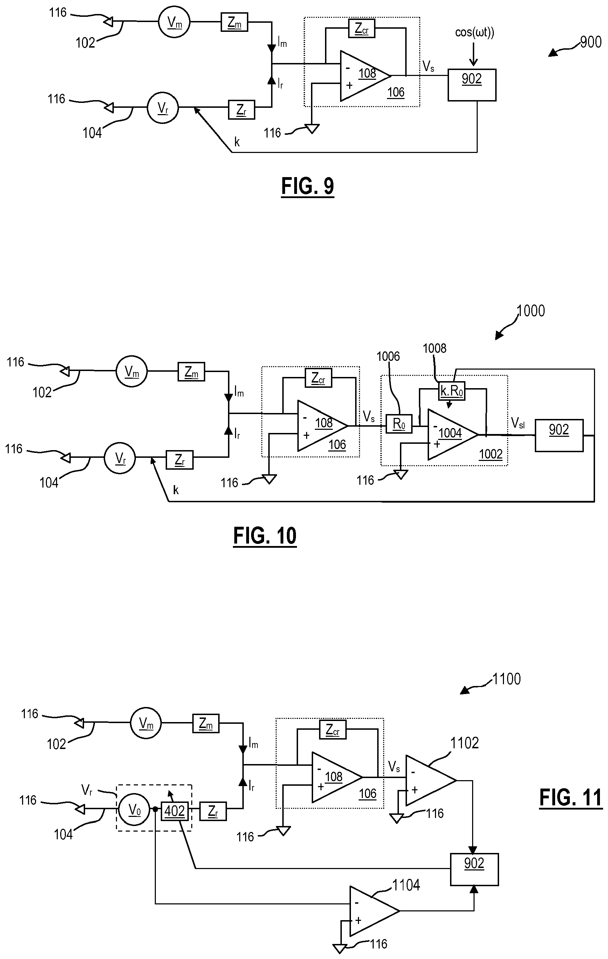

La FIGURE 9 est une représentation schématique d'un autre exemple de réalisation d'un dispositif de mesure d'impédance selon l'invention.

Le dispositif de mesure d'impédance 900 de la FIGURE 9, comprend tous les éléments du dispositif 300 de la FIGURE 3.

A la différence du dispositif 300, dans le dispositif 900 le bloc de démodulation synchrone 110, le bloc d'intégration 112 et le module de commande 114 sont intégrés dans un microcontrôleur 902.

Alternativement, le microcontrôleur 902 peut calculer une valeur de l'impédance à mesurer $Z_m$ à partir d'une ou de plusieurs mesures de signal d'erreur $V_s$ comme expliqué en relation avec la FIGURE 3, sans reproduire le fonctionnement d'une boucle de contre réaction.

Le dispositif 900 peut être combiné à chacun des dispositifs des FIGURES 4-8.

La FIGURE 10 est une représentation schématique d'un autre exemple de réalisation d'un dispositif de mesure d'impédance selon l'invention.

Le dispositif de mesure d'impédance 1000 de la FIGURE 10, comprend tous les éléments du dispositif 900 de la FIGURE 9.

Le dispositif de mesure d'impédances 1000 comprend également un amplificateur de linéarisation 1002 placé en aval de l'électronique de détection 106. Cet amplificateur de linéarisation 1002 peut recevoir en entrée le signal $V_s(t)$ alternatif, tel qu'issu de l'amplificateur transimpédance 108. Il peut également être implémenté dans un dispositif avec un démodulateur 110, tel que le dispositif 300, et recevoir en entrée le signal d'amplitude démodulé $V_s$.

L'amplificateur de linéarisation 1002 a un gain $G_l$ qui varie de manière proportionnelle à la variable de commande k.

Pour cela il peut être réalisé sous la forme d'un amplificateur inverseur avec un amplificateur opérationnel 1004 avec une résistance d'entrée 1006 par exemple de valeur $R_0$ et une résistance de contre-réaction 1008 de type potentiomètre numérique dont la résistance $R_p(k)$ varient linéairement selon la variable de commande numérique k : $R_p(k) =$

$kR_0$.

Le gain de l'amplificateur de linéarisation 1002 s'écrit alors :

$$G_l = -k.R_O/R_O = -k$$

En utilisant l'expression du signal d'erreur $V_s$ établie en relation avec la FIGURE 3, on obtient en sortie de l'amplificateur de linéarisation 1002 un signal d'erreur linéarisé $V_{sl}$ :

$$V_{sl}(t) = k.Z_{cr}[V_m(t)/Z_m + I_o(t)/k] = k.V_m(t) \, Z_{cr}/Z_m + I_o(t)]$$

L'amplitude correspondante du signal d'erreur linéarisé, en tenant compte du fait que les courants dans les branches de mesure et de référence sont en opposition de phase, ou de polarité opposée, est :

$$V_{sl} = k.V_m \, Z_{cr}/Z_m - I_o$$

On obtient donc un signal d'erreur linéarisé $V_{sl}$ qui dépend linéairement de la variable de commande k. Ce signal d'erreur linéarisé $V_{sl}$ peut avantageusement être utilisé par un microcontrôleur 902 pour calculer une valeur de l'impédance à mesurer $Z_m$ à partir d'une ou de plusieurs mesures de signal d'erreur $V_s$. Il peut également être utilisé dans un fonctionnement en boucle fermée (numérique ou analogique) pour assurer une convergence rapide.

La FIGURE 11 est une représentation schématique d'un autre exemple de réalisation d'un dispositif de mesure d'impédance selon l'invention.

Le dispositif de mesure d'impédance 1100 de la FIGURE 11, comprend tous les éléments du dispositif 900 de la FIGURE 9.

Dans le dispositif 1100 de la FIGURE 11, le microcontrôleur 902 ne réalise pas de démodulation synchrone.

A la place, le dispositif 1100 comprend en plus un premier comparateur 1102 disposé entre l'amplificateur transimpédance 108 et le microcontrôleur 902 et un deuxième comparateur 1104 disposé entre la source de tension d'amplitude fixe $V_0$ de la branche de référence 104 et le microcontrôleur 902.

Le comparateur 1102 disposé en sortie de l'amplificateur transimpédance 108 ne détecte que le signe du signal de mesure alternatif $V_s$ fourni par l'amplificateur transimpédance 108, à savoir négatif ou positif. Suivant le signe de l'erreur donnée par l'amplitude du signal de sortie $V_s$, on obtient en sortie du comparateur 1102 un signal alternatif en phase ou en opposition de phase avec un signal de référence issu de la source $V_0$, et discrétisé par le comparateur 1104. On peut alors simplement détecter cette condition de phase, par exemple avec le microprocesseur 902, et réaliser une mesure de type « par approximations successives » en éliminant complètement le besoin d'une démodulation du signal d'erreur $V_s$.

Le dispositif 1100 peut être combiné à chacun des dispositifs des FIGURES 4-8.

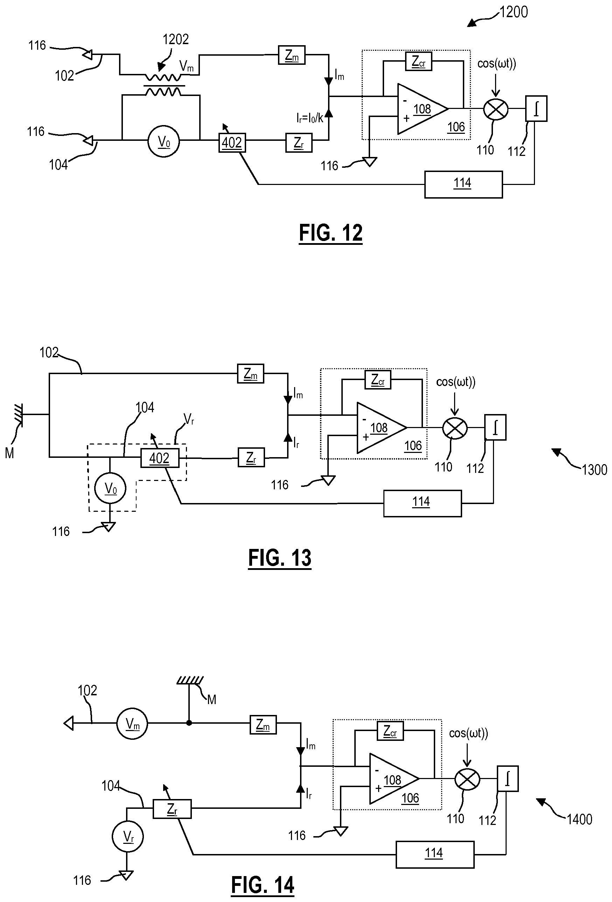

La FIGURE 12 est une représentation schématique d'un autre exemple de réalisation d'un dispositif de mesure d'impédance selon l'invention.

Le dispositif de mesure d'impédance 1200 de la FIGURE 12, comprend tous les éléments du dispositif 400 de la FIGURE 4, sauf la source de mesure $V_m$ de la branche de mesure 102.

A la différence du dispositif 400, dans le dispositif 1200, la branche de mesure 102 est alimentée par la source alternative d'amplitude fixe $V_0$ grâce à un transformateur 1202, par exemple inductif.

Inversement, la branche de référence 104 peut être alimentée par une source alternative présente dans la branche de mesure, et un transformateur 1202, par exemple inductif.

Le dispositif 1200 peut être combiné à chacun des dispositifs des FIGURES 4-11.

La FIGURE 13 est une représentation schématique d'un autre exemple de réalisation d'un dispositif de mesure d'impédance.

Le dispositif de mesure d'impédance 1300 de la FIGURE 13, comprend tous les éléments du dispositif 400 de la FIGURE 4 sauf la source de référence $V_m$.

A la différence du dispositif 400, dans le dispositif 1300, l'impédance à mesurer $Z_m$ est reliée à une masse électrique M, qui peut être une masse générale telle que la terre par exemple, différente du potentiel de référence 116 à la fréquence de travail.

La source de tension alternatif fixe $V_0$ alimente à la fois la branche de référence 104 et la branche de mesure 102 par l'intermédiaire de la masse commune M. La source $V_0$ est alors positionnée entre le potentiel de référence 116 et la masse M et établi donc ce potentiel électrique alternatif de référence 116, qui est différent du potentiel de masse M à la fréquence de travail. Les autres éléments du dispositif 1300 représentés, dont en particulier l'électronique de détection 106 peuvent avantageusement être alimentés par des alimentations référencées au potentiel de référence 116, pour éviter les couplages parasites avec la masse M.

Dans ces conditions, vu du potentiel électrique alternatif 116, la masse électrique M oscille par rapport au potentiel de référence 116. Dans ces conditions, et vue par rapport au potentiel de référence 116, la branche de mesure 102 se voit comme étant alimenté par la source fixe $V_0$. Pour les mêmes raisons qu'expliqué précédemment, l'impédance à mesurer $Z_m$ est également polarisée au potentiel de cette source $V_0$.

La branche de référence 104 peut être alimentée également par la source $V_0$ associée à l'étage de gain 402, ou par une source dérivée de la source $V_0$, par exemple au travers d'un diviseur de tension résistif ou au travers d'un transformateur comme illustré à la FIGURE 12.

La branche de référence 104 peut également être alimentée par une source $V_r$ distincte, comme illustré à la FIGURE 3, auquel cas c'est la source $V_m$ de la branche de mesure qui est positionnée entre le potentiel de référence 116 et la masse M.

La configuration décrite en référence à la FIGURE 13 peut être mise en oeuvre dans le dispositif 500 de la FIGURE 5.

De plus, la configuration décrite en référence à la FIGURE 13 peut être mise en oeuvre dans le dispositif 600 de la FIGURE 6, en remplaçant la source fixe $V_0$ par la source fixe $V_r$ et en utilisant l'impédance variable $Z_r$ de la FIGURE 6.

La FIGURE 14 donne un exemple de réalisation d'un tel dispositif, dans une configuration dans laquelle la branche de mesure 102 est alimentée par une source $V_m$ distincte, positionnée entre le potentiel de référence 116 et la masse M.

De manière générale, le dispositif 1300 ou 1400 peut être combiné à chacun des dispositifs des FIGURES 4-11.

Dans le cas où les dispositifs selon l'invention, en particulier les dispositifs 1300 et 1400, sont utilisés pour la détection capacitive d'objets, le potentiel 116 peut être un potentiel alternatif, dit de garde, utilisée pour garder les électrodes de mesure par des électrodes de garde. L'utilisation d'un tel potentiel de garde est bien connue et ne sera pas décrite plus en détail ici.

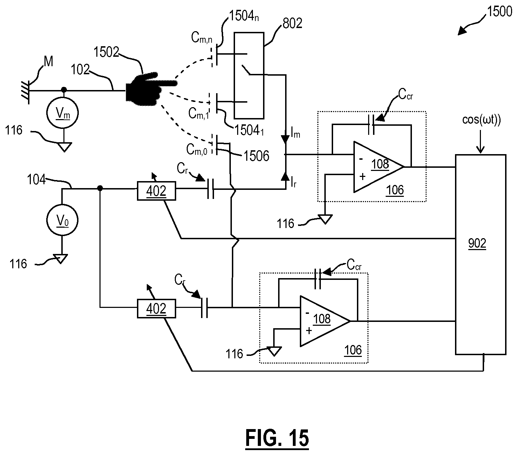

La FIGURE 15 est une représentation schématique d'un exemple de réalisation d'un dispositif de détection capacitive d'objet(s).

Le dispositif 1500, représenté sur la FIGURE 15, est utilisé pour mesurer l'impédance capacitive correspondant à chacune des capacités $C_{m,1}$-$C_{m,n}$, et $C_{m,0}$ formée entre un objet, et en particulier une main 1502 électriquement référencée au potentiel de masse M, et une pluralité d'électrodes de mesure capacitives, respectivement $1504_1$-$1504_n$ et 1506.

Comme expliqué plus haut en référence aux FIGURES 4-6 l'impédance capacitive $Z_{m,i}=(1/C_{m,i})$ est directement proportionnelle à la distance entre l'objet 1502 et l'électrode de mesure 1504i, et l'impédance capacitive $Z_{m,0}=(1/C_{m,0})$ est directement proportionnelle à la distance entre l'objet 1502 et l'électrode de mesure 1506.

Le dispositif 1500 comprend une première voie de mesure avec un moyen de scrutation 802 permettant d'interroger séquentiellement des électrodes de mesure $1504_1$-$1504_n$, comme expliqué à la FIGURE 8a.

Le dispositif 1400 comprend également une seconde voie de mesure permettant d'interroger en parallèle une électrode de mesure 1506, comme expliqué à la FIGURE 8b.

Bien entendu, le dispositif 1400 peut aussi ne comprendre qu'une voie de mesure séquentielle, ou que des voies de mesures parallèles, ou une pluralité de voies de mesure séquentielles et parallèles.

Les branches de référence 104 de la première et de la seconde voie de mesure sont alimentées par une source commune d'amplitude fixe $V_0$ qui alimente respectivement des étages de gain 402 contrôlé par des variables de commande k, comme expliqué en relation avec la FIGURE 4. Les branches de mesure 102 de la première et de la seconde voie de mesure sont alimentées par une source $V_m$ positionnée entre une masse M et le potentiel de référence 116 (qui est déterminé par cette source $V_m$). En pratique, la source $V_m$ est reliée aux branches de mesure 102 par l'intermédiaire de la masse M et de l'objet 1502.

Alternativement, les sources $V_0$ et $V_m$ des branches de référence et de mesure peuvent être réalisées par une même source, directement comme illustré à la FIGURE 13, ou par l'intermédiaire d'un diviseur de tension résistif ou d'un transformateur comme illustré à la FIGURE 12.

Sur la branche de mesure 102 de la première voie de mesure, le moyen de scrutation 802 est utilisé pour mesurer, à tour de rôle, la valeur de l'impédance capacitive $1/C_{m,i}$ pour chacune des électrodes de mesure 1504i, comme décrit en référence à la FIGURE 8a.

La branche de référence 104 des premières et secondes voies comporte une impédance de référence $1/C_r$ purement capacitive et formée, chacune, par une capacité $C_r$. De plus, l'impédance de contre-réaction utilisée pour l'amplificateur transimpédance ou dans ce cas de charge 108 des premières et secondes voies est une impédance purement capacitive $1/C_{cr}$ et formée par une capacité $C_{cr}$.

Le dispositif 1400 comprend en outre le microcontrôleur 902 intégrant le bloc de démodulation synchrone 110, le bloc d'intégration 112 et le module de commande 114 des premières et secondes voies.

Les amplificateurs transimpédance ou de charge 108 et optionnellement le microcontrôleur 902 sont alimentés par des alimentations référencées au potentiel de référence 116, pour minimiser les capacités de fuite.

Il est à noter que, comme expliqué précédemment, toutes les capacités à mesurer $C_{m,i}$ sont polarisées au même potentiel de la source $V_m$, qui correspond en outre au potentiel de référence 116 relativement à la masse M, et qui peut également être utilisé comme potentiel de garde comme expliqué en relation avec le dispositif 1400 de la figure 14.

Cette propriété est très importante car si toutes les électrodes de mesure capacitives $1504_1$-$1504_n$ et 1506 correspondant aux capacités à mesurer $C_{m,i}$ sont polarisées à un même potentiel de référence 116, utilisé en outre comme potentiel de garde pour polariser des éléments à proximité de ces électrodes selon des mises en oeuvre bien connues, et éventuellement utilisé en outre comme potentiel de référence des alimentations de l'électronique comme expliqué précédemment, on obtient ainsi une électronique de détection capacitive avec une sensibilité optimale dans laquelle toutes les capacités de couplage parasites et les capacités de fuite peuvent être éliminées.

Bien entendu, le dispositif 1500 de détection capacitive peut mettre en oeuvre une combinaison quelconque des dispositifs décrits en référence aux FIGURES 3-14.

L'invention n'est pas limitée aux exemples qui viennent d'être décrits et de nombreux aménagements peuvent être apportés à ces exemples sans sortir du cadre de l'invention tel que défini dans les revendications.

## Revendications

1. Dispositif (300;400;500;600) électronique de mesure d'impédance comprenant :

   - une branche (102), dite de mesure, comportant une impédance à mesurer ($Z_m$) de nature essentiellement capacitive et une source électrique alternative ($V_m$), dite source de mesure; et
   - au moins une branche (104), dite de référence, comportant une impédance ($Z_r$), dite impédance de référence, de nature essentiellement capacitive ($C_r$) ;

   **caractérisé en ce qu'**il comprend en outre :

   - une électronique (106), dite de détection, configurée pour fournir un signal d'erreur ($V_s$) dépendant d'une somme algébrique d'un courant ($I_r$) circulant dans l'au moins une branche de référence (104) et d'un courant ($I_m$) circulant dans la branche (102) de mesure ; et
   - au moins un moyen (402 ;602,604), dit d'ajustement, réalisant une modification du courant ($I_r$) dans l'au moins une branche de référence de manière inversement proportionnelle à une variable de commande (k), de façon à obtenir une mesure directe de l'impédance à mesurer ($Z_m$) en fonction du signal d'erreur ($V_s$) et de la variable de commande (k), ladite source de mesure ($V_m$) étant d'amplitude fixe par rapport à la variable de commande (k) ou indépendante de ladite variable de commande (k).

2. Dispositif (300;400;500) selon la revendication précédente, **caractérisé en ce que**, pour au moins une branche de référence (104), le moyen d'ajustement (402) est configuré pour réaliser une modification de l'amplitude d'une tension délivrée à ladite branche de référence (104), de manière inversement proportionnelle à la variable de commande (k).

3. Dispositif (400;500) selon la revendication précédente, **caractérisé en ce que** le moyen d'ajustement comprend un amplificateur (402) dont le gain varie de manière inversement proportionnelle à la variable de commande (k), et disposé en aval d'une source de tension ($V_0$).

4. Dispositif (400;500) selon la revendication 2, **caractérisé en ce que** le moyen d'ajustement comprend :

   - un amplificateur (404), et
   - au moins un premier potentiomètre numérique (408), utilisé comme résistance d'entrée dudit amplificateur (404), et dont la résistance est ajustée proportionnellement à la variable de commande (k).

5. Dispositif (600) selon l'une quelconque des revendications précédentes, **caractérisé en ce que**, pour au moins une branche de référence (104), le moyen d'ajustement est configuré pour réaliser une modification de l'impédance de référence ($Z_r$) de ladite branche de référence (104), de manière proportionnelle à la variable de commande (k).

6. Dispositif (600) selon la revendication précédente, **caractérisé en ce que** le moyen d'ajustement comprend :

   - un ensemble d'au moins deux impédances ($602_0$-$602_7$) disposées en série, et

- au moins un, en particulier plusieurs, interrupteur(s) ($604_0$-$604_7$) commandable(s), prévu(s), chacun, pour court-circuiter ou non une desdites impédances ($602_0$-$602_7$).

7. Dispositif (700) selon l'une quelconque des revendications précédentes, **caractérisé en ce qu'**il comprend :

   - au moins deux branches de référence ($104_1$-$104_2$) comprenant des impédances de référence ($Z_{r,1}$,$Z_{r,2}$) de nature différentes ; et/ou
   - au moins deux branches de référence ($104_1$-$104_2$) comprenant des impédances de référence ($Z_{r,1}$,$Z_{r,2}$) de même nature, et alimentées par des signaux en quadrature.

8. Dispositif (300;400;500;600) selon l'une quelconque des revendications précédentes, **caractérisé en ce que** ladite électronique de détection (106) comprend un amplificateur de charge (108) relié en un point de jonction de la branche de mesure (102) avec l'au moins une branche de référence (104), entre l'impédance à mesurer ($Z_m$) et l'au moins une impédance de référence ($Z_r$), et configuré pour fournir un signal d'erreur ($V_s$) dépendant de la somme algébrique du courant ($I_m$) de la branche de mesure (102) et du courant ($I_r$) de l'au moins une branche de référence (104).

9. Dispositif selon l'une quelconque des revendications précédentes, **caractérisé en ce qu'**il comprend en outre, disposé en aval de l'électronique de détection (106), un démodulateur d'amplitude (110, 902).

10. Dispositif (1000) selon l'une quelconque des revendications précédentes, **caractérisé en ce qu'**il comprend en outre, disposé en aval de l'électronique de détection (106), un amplificateur (1002) avec un gain proportionnel, et en particulier égal, à la variable de commande (k).

11. Dispositif (1200;1300;1400) selon l'une quelconque des revendications précédentes, **caractérisé en ce que** la branche de référence (104) et la branche de mesure (102) sont alimentées par une même source ($V_0$), éventuellement par utilisation d'un transformateur (1202).

12. Dispositif (1300) selon l'une quelconque des revendications précédentes, **caractérisé en ce que** :

    - l'impédance à mesurer ($Z_m$) est référencée à une masse générale (M), en particulier la terre, et
    - le courant ($I_r$) de l'au moins une branche de référence (104) est référencé à un potentiel électrique alternatif (116), dit potentiel de référence, différent de ladite masse générale (M), à une fréquence de travail ;

    ledit dispositif (1300) comprenant une source de tension alternative ($V_0$) disposée entre ledit potentiel de référence (116) et ladite masse générale (M).

13. Procédé de mesure d'impédance, en particulier d'impédance capacitive, avec un dispositif électronique de mesure d'impédance comprenant :

    - une branche (102), dite de mesure, comportant une impédance à mesurer ($Z_m$), de nature essentiellement capacitive et une source électrique alternative ($V_m$), dite source de mesure ;
    - au moins une branche (104), dite de référence, comportant une impédance ($Z_r$), dite impédance de référence, de nature essentiellement capacitive ($C_r$) ;

    **caractérisé en ce qu'**il comprend :

    - une étape d'obtention, avec une électronique (106) de détection, d'un signal d'erreur ($V_s$) dépendant d'une somme algébrique d'un courant ($I_r$) circulant dans l'au moins une branche de référence (104) et d'un courant ($I_m$) circulant dans la branche (102) de mesure ; et
    - au moins une itération d'une étape, dite d'ajustement, réalisant une modification du courant ($I_r$) dans ladite au moins une branches de référence (104) de manière inversement proportionnelle à une variable de commande (k), de façon à obtenir une mesure directe de l'impédance à mesurer ($Z_m$) en fonction du signal d'erreur ($V_s$) et de la variable de commande (k), ladite source de mesure ($V_m$) étant d'amplitude fixe par rapport à ladite variable de commande (k) ou indépendante de ladite variable de commande (k).

14. Dispositif (1500) de détection capacitive d'un objet (1502) comprenant :

    - au moins une électrode ($1504_1$-$1504_n$,1506), dite de mesure, et

EP 3 695 235 B1

- au moins un dispositif de mesure d'impédance selon l'une quelconque des revendications 1 à 12, agencé pour mesurer l'impédance capacitive formée entre ladite électrode de mesure ($1504_1$-$1504_n$,1506) et ledit objet (1502).

15. Dispositif (1500) selon la revendication précédente, **caractérisé en ce qu'**un dispositif de mesure d'impédance est commun à une pluralité d'électrodes de mesure ($1504_1$-$1504_n$), ledit dispositif de détection capacitive comprenant un moyen de scrutation (802) reliant ledit dispositif de mesure à chacune desdites électrodes de mesure ($1504_1$-$1504_n$), alternativement.

16. Equipement pour robot, en particulier amovible ou démontable, muni :

- d'au moins un dispositif de détection capacitive selon l'une quelconque des revendications 14 ou 15 ; ou
- d'au moins un dispositif de mesure d'impédance selon l'une quelconque des revendications 1 à 12.

17. Robot muni :

- d'un équipement selon la revendication 16 ; ou
- d'au moins un dispositif de détection capacitive selon l'une quelconque des revendications 14 ou 15 ; ou
- d'au moins un dispositif de mesure d'impédance selon l'une quelconque des revendications 1 à 12.

**Patentansprüche**

1. Elektronische Vorrichtung (300;400;500;600) zum Messen einer Impedanz, umfassend:

- einen sogenannten Messzweig (102), der eine zu messende Impedanz ($Z_m$) von im Wesentlichen kapazitiver Natur und eine elektrische Wechselquelle ($V_m$), Messquelle genannt, aufweist; und
- mindestens einen sogenannten Referenzzweig (104), der eine Impedanz ($Z_r$), Referenzimpedanz genannt, von im Wesentlichen kapazitiver Natur ($C_r$) aufweist;

**dadurch gekennzeichnet, dass** sie ferner umfasst:

- eine sogenannte Erfassungselektronik (106), die zum Bereitstellen eines Fehlersignals ($V_s$) konfiguriert ist, das von einer algebraischen Summe eines Stroms ($I_r$), der in dem mindestens einen Referenzzweig (104) zirkuliert, und eines Stroms ($I_m$), der in dem Messzweig (102) zirkuliert, abhängig ist; und
- mindestens ein sogenanntes Anpassungsmittel (402;602,604), das eine Änderung des Stroms ($I_r$) in dem mindestens einen Referenzzweig umgekehrt proportional zu einer Steuervariablen (k) vornimmt, um eine direkte Messung der zu messenden Impedanz ($Z_m$) im Zusammenhang mit dem Fehlersignal ($V_s$) und der Steuervariablen (k) zu erhalten, wobei die Messquelle ($V_m$) mit fester Amplitude relativ zu der Steuervariablen (k) oder unabhängig von der Steuervariablen (k) ist.

2. Vorrichtung (300;400;500) nach dem vorstehenden Anspruch, **dadurch gekennzeichnet, dass** das Anpassungsmittel (402) für mindestens einen Referenzzweig (104) zum Vornehmen einer Änderung der Amplitude einer Spannung, die dem Referenzzweig (104) zugeführt wird, umgekehrt proportional zu der Steuervariablen (k) konfiguriert ist.

3. Vorrichtung (400;500) nach dem vorstehenden Anspruch, **dadurch gekennzeichnet, dass** das Anpassungsmittel einen Verstärker (402) umfasst, dessen Verstärkungsgrad umgekehrt proportional zu der Steuervariablen (k) variiert, und der stromabwärts einer Spannungsquelle ($V_0$) angeordnet ist.

4. Vorrichtung (400;500) nach Anspruch 2, **dadurch gekennzeichnet, dass** das Anpassungsmittel umfasst:

- einen Verstärker (404), und
- mindestens ein erstes digitales Potentiometer (408), das als Eingangswiderstand des Verstärkers (404) genutzt wird und dessen Widerstand proportional zu der Steuervariablen (k) angepasst wird.

5. Vorrichtung (600) nach einem der vorstehenden Ansprüche,

**dadurch gekennzeichnet, dass** das Anpassungsmittel für mindestens einen Referenzzweig (104) zum Vornehmen einer Änderung der Referenzimpedanz ($Z_r$) des Referenzzweigs (104) proportional zu der Steuervariablen (k) konfiguriert ist.

6. Vorrichtung (600) nach dem vorstehenden Anspruch,
**dadurch gekennzeichnet, dass** das Anpassungsmittel umfasst:

   - einen Satz von mindestens zwei Impedanzen ($602_0$-$602_7$), die in Reihe angeordnet sind, und
   - mindestens einen, insbesondere mehrere steuerbare(n) Schalter ($604_0$-$604_7$), der /die jeweils zum Kurzschließen einer der Impedanzen ($602_0$-$602_7$) oder nicht vorgesehen ist/sind.

7. Vorrichtung (700) nach einem der vorstehenden Ansprüche,
**dadurch gekennzeichnet, dass** sie umfasst:

   - mindestens zwei Referenzzweige ($104_1$-$104_2$), umfassend Referenzimpedanzen ($Z_{r,1}$,$Z_{r,2}$) unterschiedlicher Natur; und/oder
   - mindestens zwei Referenzzweige ($104_1$-$104_2$), umfassend Referenzimpedanzen ($Z_{r,1}$,$Z_{r,2}$) gleicher Natur und die durch Quadratursignale mit Strom versorgt werden.

8. Vorrichtung (300;400;500;600) nach einem der vorstehenden Ansprüche,
**dadurch gekennzeichnet, dass** die Erfassungselektronik (106) einen Ladungsverstärker (108) umfasst, der an einem Anschlusspunkt des Messzweigs (102) mit dem mindestens einen Referenzzweig (104) zwischen der zu messenden Impedanz ($Z_m$) und der mindestens einen Referenzimpedanz ($Z_r$) verbunden ist und zum Bereitstellen eines Fehlersignals ($V_s$) abhängig von der algebraischen Summe des Stroms ($I_m$) des Messzweigs (102) und des Stroms ($I_r$) des mindestens einen Referenzzweigs (104) konfiguriert ist.

9. Vorrichtung nach einem der vorstehenden Ansprüche,
**dadurch gekennzeichnet, dass** sie ferner stromabwärts der Erfassungselektronik (106) einen Amplitudendemodulator (110, 902) umfasst.

10. Vorrichtung (1000) nach einem der vorstehenden Ansprüche,
**dadurch gekennzeichnet, dass** sie ferner stromabwärts der Erfassungselektronik (106) einen Verstärker (1002) mit einem Verstärkungsgrad proportional zu und insbesondere gleich der Steuervariablen (k) umfasst.

11. Vorrichtung (1200; 1300; 1400) nach einem der vorstehenden Ansprüche,
**dadurch gekennzeichnet, dass** der Referenzzweig (104) und der Messzweig (102) durch eine gleiche Quelle ($V_0$), möglicherweise durch Nutzung eines Transformators (1202) mit Strom versorgt werden.

12. Vorrichtung (1300) nach einem der vorstehenden Ansprüche,
**dadurch gekennzeichnet, dass:**

   - die zu messende Impedanz ($Z_m$) auf eine allgemeine Masse (M), insbesondere die Erde, referenziert wird, und
   - der Strom ($I_r$) des mindestens einen Referenzzweigs (104) auf ein elektrisches Wechselpotential (116), Referenzpotential genannt, das sich von der Gesamtmasse (M) unterscheidet, bei einer Arbeitsfrequenz referenziert wird;

   die Vorrichtung (1300) umfassend eine Wechselspannungsquelle ($V_0$), die zwischen dem Referenzpotential (116) und der Gesamtmasse (M) angeordnet ist.

13. Verfahren zum Messen einer Impedanz, insbesondere einer kapazitiven Impedanz, mit einer elektronischen Impedanzmessvorrichtung, umfassend:

   - einen sogenannten Messzweig (102), der eine zu messende Impedanz ($Z_m$) von im Wesentlichen kapazitiver Natur und eine elektrische Wechselquelle ($V_m$), Messquelle genannt, aufweist;
   - mindestens einen sogenannten Referenzzweig (104), der eine Impedanz ($Z_r$), Referenzimpedanz genannt, von im Wesentlichen kapazitiver Natur ($C_r$) aufweist,

   **dadurch gekennzeichnet, dass** es umfasst:

- einen Schritt zum Erhalten eines Fehlersignals ($V_s$) mit einer Erfassungselektronik (106) abhängig von einer algebraischen Summe eines Stroms ($I_r$), der in dem mindestens einen Referenzzweig (104) zirkuliert, und eines Stroms ($I_m$), der in dem Messzweig (102) zirkuliert; und
- mindestens eine Iteration eines sogenannten Anpassungsschrittes, der eine Änderung des Stroms ($I_r$) in dem mindestens einen Referenzzweig (104) umgekehrt proportional zu einer Steuervariablen (k) vornimmt, um eine direkte Messung der zu messenden Impedanz ($Z_m$) im Zusammenhang mit dem Fehlersignal ($V_s$) und der Steuervariablen (k) zu erhalten, wobei die Messquelle ($V_m$) mit fester Amplitude relativ zu der Steuervariablen (k) oder unabhängig von der Steuervariablen (k) ist.

**14.** Vorrichtung (1500) zum kapazitiven Erfassen eines Objekts (1502), umfassend:

- mindestens eine sogenannte Messelektrode ($1504_1$-$1504_n$, 1506), und
- mindestens eine Impedanzmessvorrichtung nach einem der Ansprüche 1 bis 12, die zum Messen der kapazitiven Impedanz, die zwischen der Messelektrode ($1504_1$-$1504_n$, 1506) und dem Objekt (1502) ausgebildet ist, eingerichtet ist.

**15.** Vorrichtung (1500) nach dem vorstehenden Anspruch,
**dadurch gekennzeichnet, dass** eine Impedanzmessvorrichtung einer Vielzahl von Messelektroden( $1504_1$-$1504_n$) gemeinsam ist, die kapazitive Erfassungsvorrichtung umfassend ein Abtastmittel (802), das die Messvorrichtung mit jeder der Messelektroden ($1504_1$-$1504_n$) wechselweise verbindet.

**16.** Ausrüstung für einen Roboter, insbesondere abnehmbar oder demontierbar, versehen mit:

- mindestens einer kapazitiven Erfassungsvorrichtung nach einem der Ansprüche 14 oder 15; oder
- mindestens einer Impedanzmessvorrichtung nach einem der Ansprüche 1 bis 12.

**17.** Roboter, versehen mit:

- einer Ausrüstung nach Anspruch 16; oder
- mindestens einer kapazitiven Erfassungsvorrichtung nach einem der Ansprüche 14 oder 15; oder
- mindestens einer Impedanzmessvorrichtung nach einem der Ansprüche 1 bis 12.

**Claims**

**1.** An electronic impedance measurement device (300;400;500;600) comprising:

- a branch (102), called measurement branch, comprising an impedance to be measured ($Z_m$) of essentially capacitive type and an alternating electrical source ($V_m$), called measurement source; and
- at least one branch (104), called reference branch, comprising an impedance ($Z_r$), called reference impedance, of essentially capacitive type ($C_r$);

**characterized in that** it also comprises:

- electronics (106), called detection electronics, configured to provide an error signal ($V_s$) dependent on an algebraic sum of a current ($I_r$) flowing in the at least one reference branch (104) and of a current ($I_m$) flowing in the measurement branch (102); and
- at least one means (402;602,604), called adjustment means, carrying out a change of the current ($I_r$) in the at least one reference branch **in** a manner inversely proportional to a control variable (k), so as to obtain a direct measurement of the impedance to be measured ($Z_m$) as a function of the error signal ($V_s$) and the control variable (k), said measurement source ($V_m$) being of fixed amplitude with respect to the control variable (k) or independent of said control variable (k).

**2.** The device (300;400;500) according to the preceding claim, **characterized in that**, for at least one reference branch (104), the adjustment means (402) is configured to change the amplitude of a voltage delivered to said reference branch (104), in a manner inversely proportional to the control variable (k).

**3.** The device (400;500) according to the preceding claim, **characterized in that** the adjustment means comprises an amplifier (402) the gain of which varies in a manner inversely proportional to the control variable (k), and arranged downstream of a voltage source ($V_0$).

4. The device (400;500) according to claim 2, **characterized in that** the adjustment means comprises:

   - an amplifier (404), and
   - at least one first digital potentiometer (408), used as input resistor of said amplifier (404), and the resistance of which is adjusted proportionally to the control variable (k).

5. The device (600) according to any one of the preceding claims, **characterized in that**, for at least one reference branch (104), the adjustment means is configured to change the reference impedance ($Z_r$) of said reference branch (104), in a manner proportional to the control variable (k).

6. The device (600) according to the preceding claim, **characterized in that** the adjustment means comprises:

   - a set of at least two impedances ($602_0$-$602_7$) arranged in series, and
   - at least one, in particular several, controllable switch(es) ($604_0$-$604_7$), each provided to short-circuit, or not, one of said impedances ($602_0$-$602_7$).

7. The device (700) according to one of the preceding claims, **characterized in that** it comprises:

   - at least two reference branches ($104_1$-$104_2$) comprising reference impedances ($Z_{r,1}$,$Z_{r,2}$) of different types; and/or
   - at least two reference branches ($104_1$-$104_2$) comprising reference impedances ($Z_{r,1}$,$Z_{r,2}$) of the same type; and supplied by signals in quadrature.

8. The device (300;400;500;600) according to any one of the preceding claims, **characterized in that** said detection electronics (106) comprise a charge amplifier (108) connected at a junction point of the measurement branch (102) with the at least one reference branch (104), between the impedance to be measured ($Z_m$) and the at least one reference impedance ($Z_r$), and configured to provide an error signal ($V_s$) dependent on the algebraic sum of the current ($I_m$) of the measurement branch (102) and of the current ($I_r$) of the at least one reference branch (104).

9. The device according to any one of the preceding claims, **characterized in that** it also comprises, arranged downstream of the detection electronics (106), an amplitude demodulator (110,902).

10. The device (1000) according to any one of the preceding claims, **characterized in that** it also comprises, arranged downstream of the detection electronics (106), an amplifier (1002) with a gain proportional, and in particular equal, to the control variable (k).

11. The device (1200;1300;1400) according to any one of the preceding claims, **characterized in that** the reference branch (104) and the measurement branch (102) are supplied by the same source ($V_0$), optionally by use of a transformer (1202).

12. The device (1300) according to any one of the preceding claims, **characterized in that**:

    - the impedance to be measured ($Z_m$) is referenced to a general ground (M), in particular earth, and
    - the current ($I_r$) of the at least one reference branch (104) is referenced to an alternating electrical potential (116), called reference potential, different from said general ground (M), at a working frequency;

    said device (1300) comprising an alternating voltage source ($V_0$) arranged between said reference potential (116) and said general ground (M).

13. A method for impedance measurement, in particular capacitive impedance, with an electronic impedance measurement device comprising:

    - a branch (102), called measurement branch, comprising an impedance to be measured ($Z_m$), of essentially capacitive type and an alternating electrical source ($V_m$), called measurement source;
    - at least one branch (104), called reference branch, comprising an impedance ($Z_r$), called reference impedance

of essentially capacitive type ($C_r$);

**characterized in that** it comprises:

- a step of obtaining, with detection electronics (106), an error signal ($V_s$) dependent on an algebraic sum of a current ($I_r$) flowing in the at least one reference branch (104) and of a current ($I_m$) flowing in the measurement branch (102); and
- at least one iteration of a step, called adjustment step, carrying out a change of the current ($I_r$) in said at least one reference branch (104) in a manner inversely proportional to a control variable (k), so as to obtain a direct measurement of the impedance to be measured ($Z_m$) as a function of the error signal ($V_s$) and the control variable (k), said measurement source ($V_m$) being of fixed amplitude with respect to the control variable (k) or independent of said control variable (k).

14. A device (1500) for the capacitive detection of an object (1502) comprising:

- at least one electrode ($1504_1$-$1504_n$,1506), called measurement electrode, and
- at least one impedance measurement device according to any one of claims 1 to 12, arranged to measure the capacitive impedance formed between said measurement electrode ($1504_1$-$1504_n$,1506) and said object (1502).

15. The device (1500) according to the preceding claim, **characterized in that** an impedance measurement device is common to a plurality of measurement electrodes ($1504_1$-$1504_n$), said capacitive detection device comprising a scanning means (802) connecting said measurement device to each of said measurement electrodes ($1504_1$-$1504_n$), alternately.

16. An item of equipment for a robot, in particular removable or detachable, equipped with:

- at least one capacitive detection device according to any one of claims 14 or 15; or
- at least one impedance measurement device according to any one of claims 1 to 12.

17. A robot equipped with:

- an item of equipment according to claim 18; or
- at least one capacitive detection device according to any one of claims 14 or 15; or
- at least one impedance measurement device according to any one of claims 1 to 12.

**FIG. 1 : Etat de la technique**

**FIG. 2 : Etat de la technique**

**FIG. 3**

**FIG. 4**

**FIG. 5**

**FIG. 6**

**FIG. 7**

**FIG. 8a**

**FIG. 8b**

FIG. 9

FIG. 10

FIG. 11

EP 3 695 235 B1

**FIG. 12**

**FIG. 13**

**FIG. 14**

**FIG. 15**

**RÉFÉRENCES CITÉES DANS LA DESCRIPTION**

**Documents brevets cités dans la description**

- FR 2756048

- EP 0063520 A1